# EUROPEAN PATENT APPLICATION

(11) **EP 4 687 174 A1**
(43) Date of publication of application: **04.02.2026**
(21) Application number: 25184057.5
(22) Date of filing: 19.06.2025
(51) Int. Cl.: H01L 23/532, H01L 23/485, H10D 30/00, H01L 21/768, H01L 21/285

(54) **BACKSIDE CONTACT STRUCTURE WITH ENHANCED OHMIC CONTACT**

(30) Priority: 29.07.2024 US 202418786729
(71) Applicant: Intel Corporation, Santa Clara, CA 95054 (US)
(72) Inventor: YEUNG, Chun Wing, Portland, OR 97229 (US); CHU, Tao, Portland, OR 97229 (US); XU, Guowei, Portland, OR 97229 (US); CHAO, Robin, Portland, OR 97209 (US); ZHANG, Feng, Portland, OR 97229 (US); HUNG, Ting-Hsiang, Santa Clara, CA 95051 (US); LIN, Chia-Ching, Portland, OR 97229 (US); ZHANG, Yang, Rio Rancho, NM 87124 (US); ZHANG, Kan, Hillsboro, OR 97123 (US); JANG, Minwoo, Portland, OR 97229 (US); LUO, Yanbin, Portland, OR 97229 (US); PACKAN, Paul A., Hillsboro, OR 97124 (US); LINDERT, Nick, Portland, OR 97229 (US); TIWARI, Vishal, Hillsboro, OR 97123 (US); LIN, Chung-Hsun, Portland, OR 97229 (US); MURTHY, Anand, Portland, OR 97229 (US)
(74) Representative: HGF

(57) **Abstract**

Techniques are provided to form an integrated circuit having different semiconductor devices with different backside contact structures. Field effect transistors (FETs) each includes semiconductor material extending in a first direction between source and drain regions, and gate structures extending in a second direction around the semiconductor material of each FET. Different contact structures are formed on the source or drain regions of the n-channel FETs compared to the p-channel FETs. A backside contact structure on an n-channel source or drain region includes a first layer of phosphorous-doped titanium, a second layer that includes scandium, and a third layer that includes a metal, such as molybdenum. A backside contact structure on a p-channel source or drain region may include only a layer of metal, such as molybdenum, or the layer of metal and a layer of boron-doped titanium. The contact structures may be used to provide enhanced ohmic contact.

## Description

### BACKGROUND

As integrated circuits continue to scale downward in size, a number of challenges arise. For instance, reducing the size of memory and logic cells within the interconnect structure is becoming increasingly more difficult, as is reducing device spacing at the device layer. Due to the small size of the transistor elements, such as the transistor gate, source, or drain, it can be difficult to provide effective contacts while maintaining desired operation speeds and power requirements. Accordingly, there remain a number of non-trivial challenges with respect to forming such high-density semiconductor devices.

### BRIEF DESCRIPTION OF THE DRAWINGS

Figures 1A and 1B are cross-sectional views of different semiconductor devices in an integrated circuit that include different backside contact structures, in accordance with an embodiment of the present disclosure.
Figures 2A and 2B are cross-sectional views that illustrate one stage in an example process for forming an integrated circuit having different semiconductor devices with different backside contact structures, in accordance with an embodiment of the present disclosure.
Figures 3A and 3B are cross-sectional views that illustrate another stage in the example process for forming an integrated circuit having different semiconductor devices with different backside contact structures, in accordance with an embodiment of the present disclosure.
Figures 4A and 4B are cross-sectional views that illustrate another stage in the example process for forming an integrated circuit having different semiconductor devices with different backside contact structures, in accordance with an embodiment of the present disclosure.
Figures 5A and 5B are cross-sectional views that illustrate another stage in the example process for forming an integrated circuit having different semiconductor devices with different backside contact structures, in accordance with an embodiment of the present disclosure.
Figures 6A and 6B are cross-sectional views that illustrate another stage in the example process for forming an integrated circuit having different semiconductor devices with different backside contact structures, in accordance with an embodiment of the present disclosure.
Figures 7A and 7B are cross-sectional views that illustrate another stage in the example process for forming an integrated circuit having different semiconductor devices with different backside contact structures, in accordance with an embodiment of the present disclosure.
Figures 8A and 8B are cross-sectional views that illustrate another stage in the example process for forming an integrated circuit having different semiconductor devices with different backside contact structures, in accordance with an embodiment of the present disclosure.
Figures 9A and 9B are cross-sectional views that illustrate another stage in the example process for forming an integrated circuit having different semiconductor devices with different backside contact structures, in accordance with an embodiment of the present disclosure.
Figures 10A and 10B are cross-sectional views that illustrate another stage in the example process for forming an integrated circuit having different semiconductor devices with different backside contact structures, in accordance with an embodiment of the present disclosure.
Figures 11A and 11B are cross-sectional views that illustrate another stage in the example process for forming an integrated circuit having different semiconductor devices with different backside contact structures, in accordance with an embodiment of the present disclosure.
Figures 12A and 12B are cross-sectional views that illustrate another stage in the example process for forming an integrated circuit having different semiconductor devices with different backside contact structures, in accordance with an embodiment of the present disclosure.
Figures 13A and 13B are cross-sectional views that illustrate another stage in the example process for forming an integrated circuit having different semiconductor devices with different backside contact structures, in accordance with an embodiment of the present disclosure.
Figures 14A and 14B are cross-sectional views that illustrate another stage in the example process for forming an integrated circuit having different semiconductor devices with different backside contact structures, in accordance with an embodiment of the present disclosure.
Figures 15A and 15B are cross-sectional views that illustrate another stage in the example process for forming an integrated circuit having different semiconductor devices with different backside contact structures, in accordance with an embodiment of the present disclosure.
Figures 16A and 16B are cross-sectional views that illustrate another stage in the example process for forming an integrated circuit having different semiconductor devices with different backside contact structures, in accordance with an embodiment of the present disclosure.
Figures 17A and 17B are cross-sectional views that illustrate another stage in the example process for forming an integrated circuit having different semiconductor devices with different backside contact structures, in accordance with an embodiment of the present disclosure.
Figure 18 illustrates a cross-sectional view of a chip package containing one or more semiconductor dies, in accordance with some embodiments of the present disclosure.
Figure 19 is a flowchart of a fabrication process for forming different semiconductor devices with different backside contact structures, in accordance with an embodiment of the present disclosure.
Figure 20 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form an integrated circuit having different semiconductor devices with different backside contact structures. The techniques can be used in any number of integrated circuit applications and are particularly useful with respect to logic and memory cells, such as those cells that use finFETs or gate-all-around transistors (e.g., ribbonFETs and nanowire FETs) or forksheet transistors. In one such example, FETs (field effect transistors) each includes semiconductor material extending in a first direction between source and drain regions, and gate structures extending in a second direction around the semiconductor material of each FET. The semiconductor material of each FET may be a fin or any number of nanowires (or nanoribbons or nanosheets, as the case may be). According to some embodiments, n-channel FETs have different source or drain material compared to p-channel FETs, and thus different contact structures are formed on the source or drain regions of the n-channel FETs compared to the p-channel FETs. For example, a backside contact structure on an n-channel source or drain region includes a first layer of phosphorous-doped titanium, a second layer that includes scandium, and a third layer that includes a metal, such as molybdenum. A backside contact structure on a p-channel source or drain region may include only a layer of metal, such as molybdenum, or the layer of metal and a layer of boron-doped titanium. The contact structures may be used to provide enhanced ohmic contact to both the n-channel and p-channel devices. Numerous variations and embodiments will be apparent in light of this disclosure.

### General Overview

As previously noted above, there remain a number of non-trivial challenges with respect to integrated circuit fabrication. As devices become smaller and more densely packed, the contact area to transistor elements like the source or drain regions becomes smaller as well. This can lead to higher contact resistance, which negatively impacts the transistor performance. Some integrated circuit designs use backside contacts against the bottom surface of the source or drain regions to provide power or signal to the source or drain regions. These backside contacts often suffer from poor contact resistance. Silicide has been used to help improve the contact resistance to source or drain regions. However, silicide alone may not be enough as demand increases for greater and greater transistor performance.

Thus, and in accordance with an embodiment of the present disclosure, techniques are provided herein to provide different backside contact structures to the source or drain regions of different semiconductor devices. According to some embodiments, the contact structures are different for n-channel devices (NMOS) compared to p-channel devices (PMOS) due to the compositionally different source or drain material. For example, NMOS devices may include source or drain regions of silicon doped with phosphorous while PMOS devices may include source or drain regions of silicon germanium doped with boron. Other examples may user different n-type and p-type doped semiconductor material systems for the source and drain regions, such as group III-V material systems like indium gallium arsenide doped with silicon (for n-type) or indium gallium arsenide doped with beryllium (for p-type).

A material layer that includes scandium may be used to reduce the resistance of the backside contact to the source or drain region of n-type (e.g., NMOS) devices, according to some embodiments. In an example, the NMOS backside contact structure includes a first layer having phosphorous-doped titanium, a second layer having scandium, and a third metal layer. The third metal layer may include molybdenum, although other metals can be used as well (e.g., ruthenium, cobalt, or tungsten). In contrast, the PMOS backside contact structure may include only a metal layer having molybdenum (e.g., or other metal, such as ruthenium, cobalt, or tungsten), or a layer having boron-doped titanium on the metal layer. The PMOS contact does not include a layer having scandium, according to some embodiments.

According to an embodiment, an integrated circuit includes a semiconductor device having a semiconductor region extending in a first direction from a source or drain region and a gate structure extending in a second direction over the semiconductor region, a dielectric layer beneath the gate structure, and a contact structure on a bottom surface of the source or drain region and adjacent to the dielectric layer. The contact structure includes a first conductive layer on the surface of the source or drain region, and a second conductive layer that includes scandium on the first conductive layer.

According to another embodiment, an integrated circuit includes a first semiconductor device having a first semiconductor region extending in a first direction from a first source or drain region and a first gate structure extending in a second direction over the first semiconductor region, and a second semiconductor device having a second semiconductor region extending in the first direction from a second source or drain region and a second gate structure extending in the second direction over the second semiconductor region. Additionally, a dielectric layer is beneath the first and second gate structures, a first contact structure is on a bottom surface of the first source or drain region and adjacent to the dielectric layer, and a second contact structure is on a bottom surface of the second source or drain region and adjacent to the dielectric layer. The first contact structure includes a first conductive layer having scandium, and the second contact structure includes a second conductive layer having molybdenum. In some such examples, the first semiconductor device is an n-channel device and the second semiconductor device is a p-channel device.

According to an embodiment, a method of forming an integrated circuit includes: forming a fin comprising semiconductor material, the fin extending above a substrate; forming a dielectric layer adjacent to a subfin of the fin; forming sacrificial gates and spacer structures over the fin; removing portions of the fin not covered by the sacrificial gates and spacer structures; removing a portion of the subfin to form a subfin recess; forming a sacrificial plug within the subfin recess; forming a source or drain region at exposed ends of the semiconductor material above the sacrificial plug; removing the substate to expose a backside of the sacrificial plug; removing the sacrificial plug from the backside; forming a first conductive layer on a bottom surface of the source or drain region; forming a second conductive layer on the first conductive layer, wherein the second conductive layer comprises scandium; and forming a conductive contact beneath the second conductive layer.

The techniques can be used with any type of planar or non-planar transistors, including finFETs (sometimes called double-gate transistors, or tri-gate transistors), or nanowire and nanoribbon transistors (sometimes called gate-all-around transistors), or forksheet transistors, to name a few examples. The source and drain regions can be, for example, epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process), or any other gate formation process. Any number of semiconductor materials can be used in forming the transistors, such as group IV materials (e.g., silicon, germanium, silicon germanium) or group III-V materials (e.g., gallium arsenide, indium gallium arsenide, indium phosphide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of a material layer that includes scandium as part of a backside contact under a source or drain region. In some embodiments, the material layer with scandium may be one layer in a multi-layer conductive contact structure. The other material layers may include a layer having titanium and phosphorous and another layer having a metal, such as molybdenum.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

### Architecture

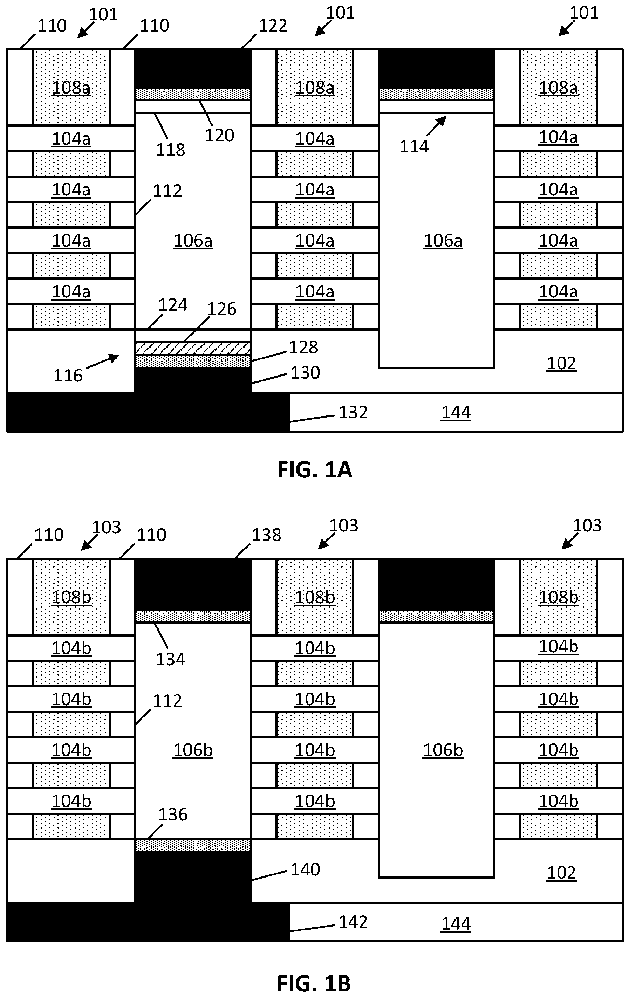

Figure 1A is a cross-section view taken through semiconductor devices 101 along a 'fin' direction that illustrates the semiconductor bodies extending between source or drain regions of each of the semiconductor devices, in accordance with an embodiment of the present disclosure. Figure 1B illustrates a cross-section view taken through different semiconductor devices 103 on the same die as semiconductor devices 101. Semiconductor devices 103 may be further along the same fin as semiconductor devices 101 or may be part of a different fin extending parallel to the fin of semiconductor devices 101. Each of the semiconductor devices may be, for instance, non-planar metal oxide semiconductor (MOS) transistors, such as tri-gate (e.g., finFET) or gate-all-around (GAA) transistors, although other transistor topologies and types could also benefit from the techniques provided herein. The examples herein illustrate semiconductor devices with a GAA structure (e.g., having nanoribbons, nanowires, or nanosheets that extend between source and drain regions). Other examples may have a forksheet structure having a p-type device and an n-type device separated by a dielectric spine or structure. According to some embodiments, semiconductor devices 101 are n-channel devices (e.g., NMOS) and semiconductor devices 103 are p-channel devices (e.g., PMOS).

The semiconductor material used in each of the semiconductor devices may be formed from or on a semiconductor substrate. According to some embodiments, the substrate is removed following the completion of all topside processing and is replaced with a base dielectric structure 102. Base dielectric structure 102 may represent any number of dielectric layers and/or materials. In some examples, base dielectric structure 102 includes one or more layers of silicon dioxide.

The one or more semiconductor regions of the devices may include fins that can be, for example, native to the substrate (formed from the substrate itself), such as silicon fins etched from a bulk silicon substrate. Alternatively, the fins can be formed of material deposited onto the substrate. In one such example case, a blanket layer of SiGe can be deposited onto a silicon substrate, and then patterned and etched to form a plurality of SiGe fins extending from that substrate. In still other embodiments, the fins include alternating layers of material (e.g., alternating layers of silicon and SiGe) that facilitates forming of nanowires and nanoribbons and nanosheets during a gate forming process where one type of the alternating layers is selectively etched away so as to liberate the other type of alternating layers within the channel region, so that a gate-all-around process or a forksheet gate process can then be carried out. Again, the alternating layers can be blanket deposited and then etched into fins or deposited into fin-shaped trenches, in some examples.

Each semiconductor device 101 includes one or more semiconductor regions (also called channel regions), such as one or more nanoribbons 104a extending between epitaxial source or drain regions 106a in the first direction. Similarly, each semiconductor device 103 includes one or more semiconductor nanoribbons 104b extending between epitaxial source or drain regions 106b in the first direction. First gate structures 108a extend over nanoribbons 104a of semiconductor devices 101 in a second direction (e.g., into and out of the page) to form the transistor gates of semiconductor devices 101 and second gate structures 108b extend over nanoribbons 104b of semiconductor devices 103 in the second direction to form the transistor gates of semiconductor devices 103.

Any of source or drain regions 106a/106b may act as either a source region or a drain region, depending on the application and dopant profile. Any semiconductor materials suitable for source and drain regions can be used (e.g., group IV and group III-V semiconductor materials) for any of the illustrated source or drains regions 106a/106b. In any such cases, the composition and doping of source or drain regions 106a and 106b may be the same or different, depending on the polarity of the transistors. In an example, semiconductor devices 101 are n-channel devices having a high concentration of n-type dopants in the associated source or drain regions 106a, and semiconductor devices 103 are p-channel devices having a high concentration of p-type dopants in the associated source or drain regions 106b. Example p-type dopants include boron and example n-type dopants include phosphorous or arsenic. Any number of source and drain configurations and materials can be used. In some examples, source or drain regions 106a include silicon doped with phosphorous and source or drain regions 106b include silicon germanium doped with boron.

The gate structures 108a/108b may each include a gate electrode that is made up of a conductive fill and one or more metal workfunction layers, according to some embodiments. The gate structures 108a/108b also include a gate dielectric that may represent any number of dielectric layers. The conductive fill may include any sufficiently conductive material such as a metal, metal alloy, or doped polysilicon. In some examples, the conductive fill includes tungsten (W), although other metals or conductive materials may be used, such as aluminum (Al), molybdenum (Mo), ruthenium (Ru), cobalt (Co), or doped polysilicon. In some embodiments, semiconductor devices 101 are n-channel devices having gate structures 108a with one or more workfunction layers of tungsten. Other metal workfunction layers of n-channel devices can include tantalum nitride (TaN). In some embodiments, semiconductor devices 103 are p-channel devices having gate structures 108b with one or more workfunction layers of molybdenum nitride (MoN). Other metal workfunction layers of p-channel devices can include tantalum nitride (TaN) and titanium nitride (TiN).

The gate dielectric of each gate structure 108a/108b may include any suitable gate dielectric material(s). In some embodiments, the gate dielectric includes a layer of native oxide material (e.g., silicon dioxide germanium dioxide, or SiGe oxide) on nanoribbons 104a/104b, and a layer of high-k dielectric material (e.g., hafnium oxide or aluminum oxide) on the native oxide. According to some embodiments, spacer structures 110 and inner spacers 112 are present along the sidewalls of gate structures 108a/108b. Spacer structures 110 and inner spacers 112 may be any suitable dielectric material, such as silicon nitride, and provide separation between a given gate structure 108a/108b and the adjacent source or drain region 106a/106b. Inner spacers 112 may separate adjacent nanoribbons 104a/104b from one another along a third direction (e.g., a vertical direction).

According to some embodiments, one or more of the n-type source or drain regions 106a include a topside contact structure 114 on a top surface of the one or more source or drain regions 106a. Additionally, one or more of the n-type source or drain regions 106a include a backside contact structure 116 on a bottom surface of the one or more source or drain regions 106a. A given source or drain region 106a may include only a topside contact structure 114, only a backside contact structure 116, or both topside and backside contact structures 114 and 116. Each of topside contact structure 114 and backside contact structure 116 may include any number of conductive material layers to enhance the ohmic contact between the semiconductor material of source or drain region 106a and a metal contact.

According to some embodiments, topside contact structure 114 includes a first conductive layer 118 on the top surface of source or drain region 106a and a second conductive layer 120 on first conductive layer 118. First conductive layer 118 may include silicide (e.g., having titanium), or may include phosphorous-doped titanium. Second conductive layer 120 may include a metal layer, such as a layer of molybdenum. A topside contact 122 may be formed over topside contact structure 114, such that topside contact structure 114 is between topside contact 122 and source or drain region 106a. Topside contact 122 can include any suitable conductive material, such as tungsten, molybdenum, ruthenium, cobalt, or other metals.

According to some embodiments, backside contact structure 116 includes a third conductive layer 124 on the bottom surface of source or drain region 106a, a fourth conductive layer 126 on third conductive layer 124, and a fifth conductive layer 128 on fourth conductive layer 126. Third conductive layer 124 may include silicide (e.g., having titanium), or may include phosphorous-doped titanium. In some examples, third conductive layer 124 is the same material as first conductive layer 118. According to some embodiments, fourth conductive layer 126 includes scandium. Fifth conductive layer 128 may include a metal layer, such as a layer of molybdenum. While dimensions may vary depending on the relative size of the semiconductor devices, third conductive layer 124 may have a thickness between about 2 nm and about 6 nm, fourth conductive layer 126 may have a thickness between about 1 nm and about 5 nm, and fifth conductive layer 128 may have a thickness between about 1 nm and about 6 nm. A backside contact 130 may be formed beneath backside contact structure 116, such that backside contact structure 116 is between backside contact 130 and source or drain region 106a. Backside contact 130 can include any suitable conductive material, such as tungsten, molybdenum, ruthenium, cobalt, or other metals.

According to some embodiments, a backside conductive trace 132 may be formed on a bottom surface of base dielectric structure 102. Backside conductive trace 132 may include any suitable conductive material, such as tungsten, molybdenum, ruthenium, cobalt, or other metals. In some examples, backside conductive trace 132 contacts backside contact 130 to deliver power or signal to the backside of source or drain region 106a.

As discussed above, the contact structures between n-channel and p-channel devices may be different to provide an enhanced ohmic contact to both device types. For example, p-channel semiconductor devices 103 may include one or more source or drain regions 106b with a topside contact structure 134 and/or with a backside contact structure 136. A given source or drain region 106b may include only a topside contact structure 134, only a backside contact structure 136, or both topside and backside contact structures 134 and 136.

According to some embodiments, topside contact structure 134 includes a metal layer, such as a layer containing molybdenum, on the top surface of source or drain region 106b. In some examples, topside contact structure 134 includes another layer containing boron-doped titanium. In such examples, the layer containing boron-doped titanium may be directly on the top surface of source or drain region 106b and the layer containing molybdenum is on the layer containing boron-doped titanium. A topside contact 138 may be formed over topside contact structure 134, such that topside contact structure 134 is between topside contact 138 and source or drain region 106b. Topside contact 138 can include any suitable conductive material, such as tungsten, molybdenum, ruthenium, cobalt, or other metals.

According to some embodiments, backside contact structure 136 includes a metal layer, such as a layer containing molybdenum, on the bottom surface of source or drain region 106b. In some examples, backside contact structure 136 includes another layer containing boron-doped titanium. In such examples, the layer containing boron-doped titanium may be directly on the bottom surface of source or drain region 106b and the layer containing molybdenum is on the layer containing boron-doped titanium. A backside contact 140 may be formed under backside contact structure 136, such that backside contact structure 136 is between backside contact 140 and source or drain region 106b. Backside contact 140 can include any suitable conductive material, such as tungsten, molybdenum, ruthenium, cobalt, or other metals. A backside conductive trace 142 may be formed on a bottom surface of base dielectric structure 102 to contact backside contact 140 and may be similar to backside conductive trace 132. A dielectric fill 144 may also be present on the backside surface such that a bottom surface of dielectric fill 144 is substantially coplanar with a bottom surface of backside conductive trace 142 and backside conductive trace 132. Dielectric fill 144 may include any suitable dielectric material (e.g., same material as base dielectric structure 102).

### Fabrication Methodology

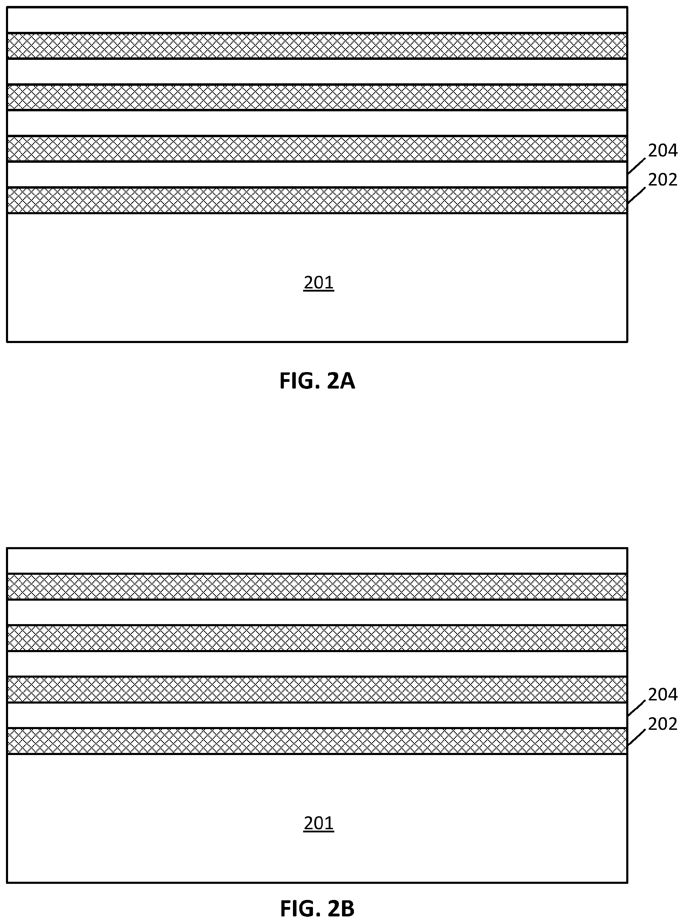

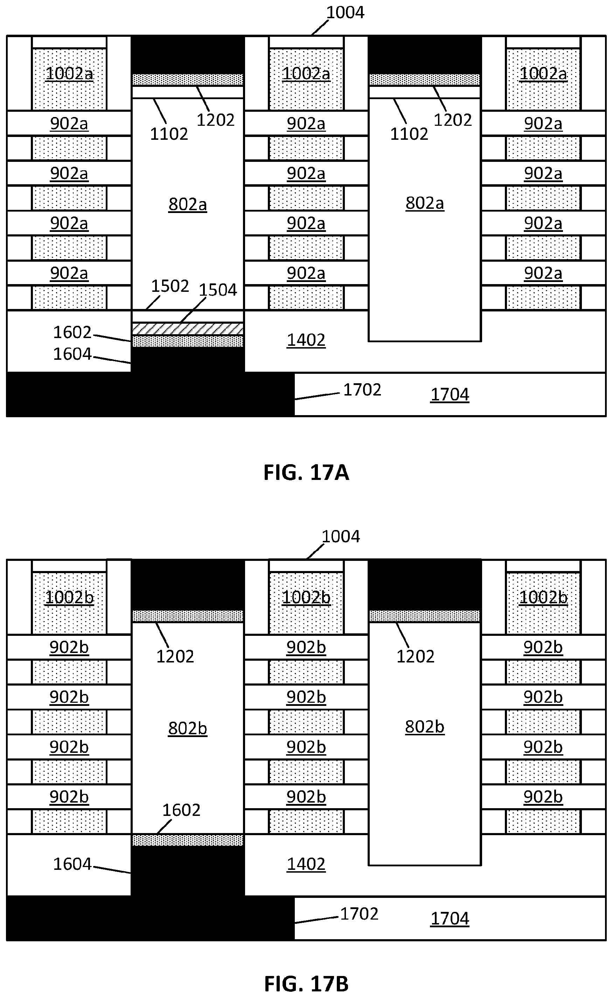

Figures 2A - 17A and 2B - 17B include cross-sectional views that collectively illustrate an example process for forming an integrated circuit having different semiconductor devices with different backside contact structures, in accordance with an embodiment of the present disclosure. Figures 2A - 17A represent a similar cross-sectional view as that of Figure 1A across a series of n-channel semiconductor devices, while Figures 2B - 17B represent a similar cross-sectional view as that of Figure 1B across a series of different p-channel semiconductor devices. Each set of figures sharing the same letter shows an example structure that results from the process flow up to that point in time, so the depicted structure evolves as the process flow continues, culminating in the structure shown in Figures 17A and 17B, which is similar to the structure shown in Figures 1A and 1B. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but other materials and process parameters may be used as well, as will be appreciated in light of this disclosure.

Figures 2A and 2B each illustrates a cross-sectional view taken through a substrate 201 having a series of material layers formed over substrate 201, according to an embodiment of the present disclosure. Alternating material layers may be deposited over substrate 201 including sacrificial layers 202 alternating with semiconductor layers 204. The alternating layers are used to form GAA transistor structures. Any number of alternating sacrificial layers 202 and semiconductor layers 204 may be deposited over substrate 201.

Substrate 201 can be, for example, a bulk substrate including group IV semiconductor material (such as silicon, germanium, or SiGe), group III-V semiconductor material (such as gallium arsenide, indium gallium arsenide, or indium phosphide), and/or any other suitable material upon which transistors can be formed. Alternatively, substrate 201 can be a semiconductor-on-insulator substrate having a desired semiconductor layer over a buried insulator layer (e.g., silicon over silicon dioxide). Alternatively, substrate 201 can be a multilayer substrate or superlattice suitable for forming nanowires or nanoribbons (e.g., alternating layers of silicon and SiGe, or alternating layers indium gallium arsenide and indium phosphide). Any number of substrates can be used.

According to some embodiments, semiconductor layers 204 have a different material composition than sacrificial layers 202. In some embodiments, semiconductor layers 204 include a semiconductor material suitable for use as a nanoribbon such as silicon (Si), SiGe, germanium, or III-V materials like indium phosphide (InP) or gallium arsenide (GaAs). Sacrificial layers 202 include a material that can be selectively removed relative to semiconductor layers 204. In some examples, for instance, semiconductor layers 204 are silicon and sacrificial layers 202 are SiGe, or vice-versa. In some other examples where SiGe is used in each of semiconductor layers 204 and in sacrificial layers 202, the germanium concentration is different between semiconductor layers 204 and sacrificial layers 202, so as to allow for etch selectivity. For example, semiconductor layers 204 may include a higher germanium content compared to sacrificial layers 202.

While dimensions can vary from one example embodiment to the next, the thickness of each semiconductor layer 204 may be between about 5 nm and about 20 nm, in some examples. In some embodiments, the thickness of each semiconductor layer 204 is substantially the same (e.g., within 1-2 nm). The thickness of each of sacrificial layers 202 may be about the same as the thickness of each semiconductor layer 204 (e.g., about 5-20 nm). Each of semiconductor layers 204 and sacrificial layers 202 may be deposited using any material deposition technique, such as chemical vapor deposition (CVD), plasma-enhanced chemical vapor deposition (PECVD), physical vapor deposition (PVD), or atomic layer deposition (ALD), or epitaxial growth.

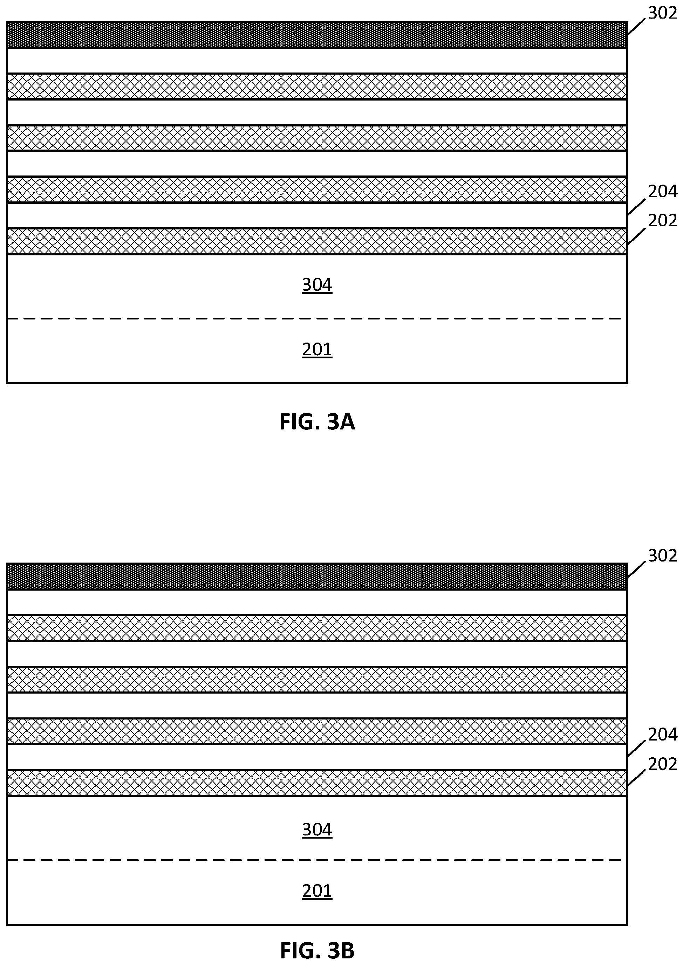

Figures 3A and 3B depict the cross-section views of the structure shown in Figures 2A and 2B, respectively, following the formation of a cap layer 302 and the subsequent formation of fins beneath cap layer 302, according to an embodiment. Cap layer 302 may be any suitable hard mask material such as a carbon hard mask (CHM) or silicon nitride. Cap layer 302 is patterned into rows to form corresponding rows of fins from the alternating layer stack of sacrificial layers 202 and semiconductor layers 204. Cap layer 302 extends along the top of each fin in a first direction. In some embodiments, Figures 3A and 3B illustrate different portions of the same fin (e.g., patterned under the same strip of cap layer 302). In some embodiments, Figures 3A and 3B illustrate portions of different parallel fins (e.g., under different parallel strips of cap layer 302).

According to some embodiments, an anisotropic etching process through the layer stack continues into at least a portion of substrate 201. Portions of substrate 201 beneath the fins are not etched and yield subfin regions 304. The etched portions of substrate 201 that are not under the fins may be filled with a dielectric fill that acts as shallow trench isolation (STI) between adjacent fins. The dielectric fill is not shown in these cross-sections as it extends in the first direction along the sides of subfin regions 304 that are into and out of the page. The dielectric fill may be any suitable dielectric material such as silicon dioxide. The subfin regions 304 represent remaining portions of substrate 201 flanked by the dielectric fill, according to some embodiments.

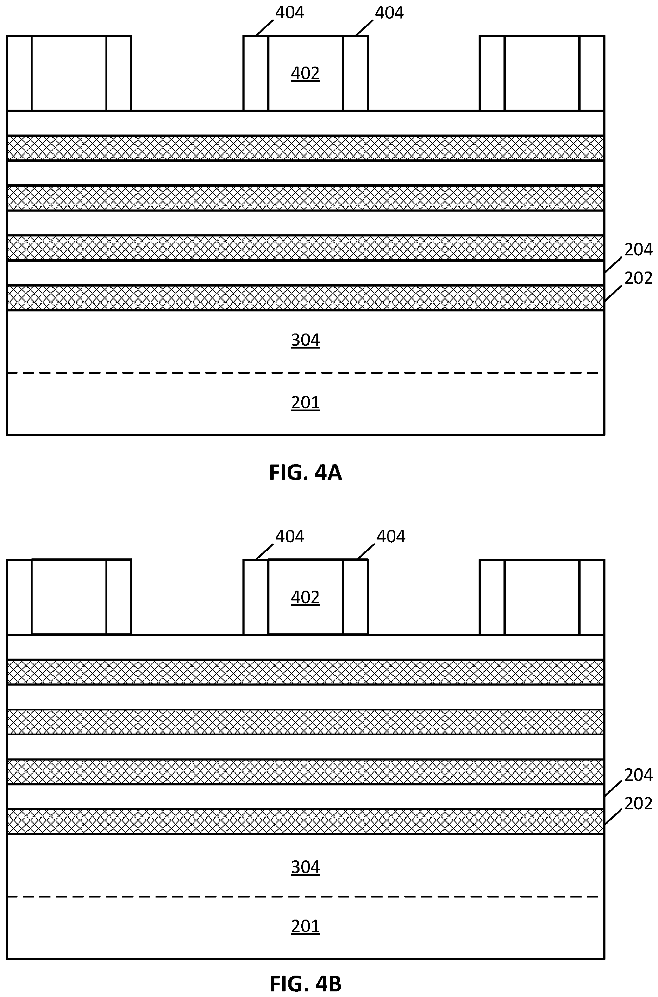

Figures 4A and 4B depict cross-section views of the structures shown in Figures 3A and 3B following the formation of sacrificial gates 402 and spacer structures 404, according to some embodiments. A gate masking layer may first be patterned in strips that extend orthogonally across each of the fins (e.g., in a second direction) in order to form corresponding sacrificial gates 402 in strips beneath the gate masking layers. Afterwards, the gate masking layers may be removed or may remain as a cap layer above each sacrificial gate 402. According to some embodiments, the sacrificial gate material is removed in all areas not protected by the gate masking layers. Sacrificial gate 402 may be any suitable material that can be selectively removed without damaging the semiconductor material of the fins. In some examples, sacrificial gate 402 includes polysilicon.

According to some embodiments, spacer structures 404 are formed along the sidewalls of sacrificial gates 402. Spacer structures 404 may be conformally deposited (e.g., CVD or ALD)_and then etched back or otherwise removed (e.g., via anisotropic or directional etch) from horizontal surfaces, such that spacer structures 404 remain mostly only on sidewalls of any exposed structures. The width of spacer structures 404 (along the first direction) may vary from one example to the next, but in some cases is in the range of 3 nm to 20 nm. According to some embodiments, spacer structures 404 may be any suitable dielectric material, such as silicon nitride, silicon carbon nitride, or silicon oxycarbonitride. In one such embodiment, spacer structures 404 comprise a nitride and the dielectric fill adjacent to subfin regions 304 comprises an oxide, so as to provide a degree of etch selectivity during final gate processing.

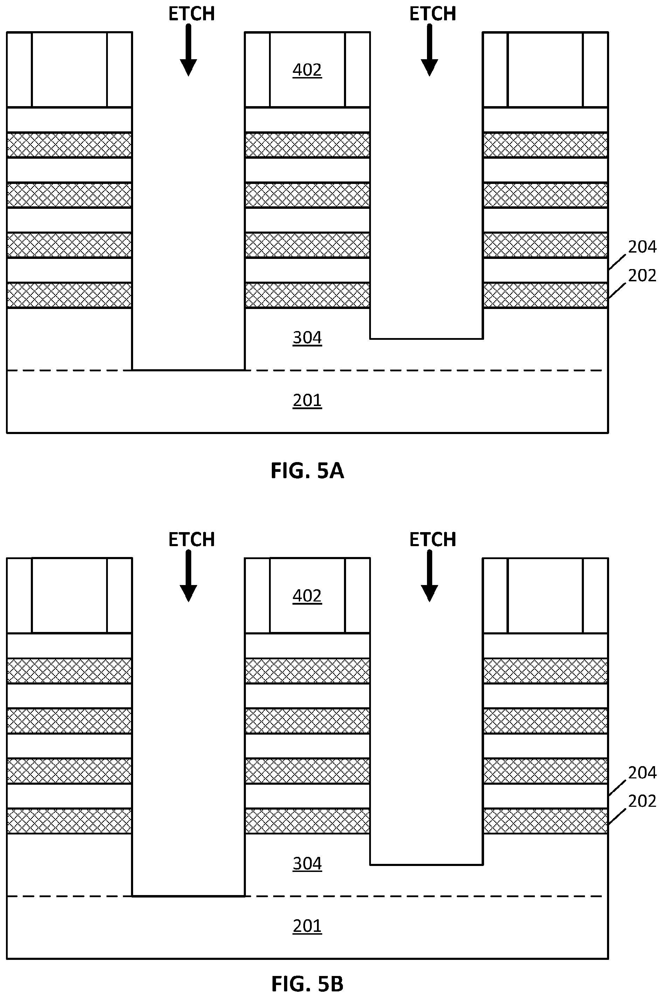

Figures 5A and 5B depict cross-section views of the structures shown in Figures 4A and 4B following the removal of exposed portions of the fins not protected by sacrificial gates 402 and spacer structures 404, according to some embodiments. The exposed fin portions may be removed using any anisotropic etching process, such as reactive ion etching (RIE) or other directional etch process. The removal of the exposed fin portions creates source or drain trenches that alternate with gate trenches (currently filled with sacrificial gates 402) along the first direction, according to some embodiments.

In some embodiments, at least a portion of subfin regions 304 is also removed such that a top surface of subfin regions 304 is recessed below a top surface of the adjacent dielectric fill. According to some embodiments, more than one etch process is performed to create recesses at different depths through subfin regions 304. In the illustrated example, the lefthand recesses are etched through at least an entire thickness of subfin regions 304, while the righthand recesses are etched through only a portion of the entire thickness of subfin regions 304. According to some embodiments, backside contacts are to be formed in the areas with recesses that extend through at least the entire thickness of subfin regions 304, as will be described in more detail herein.

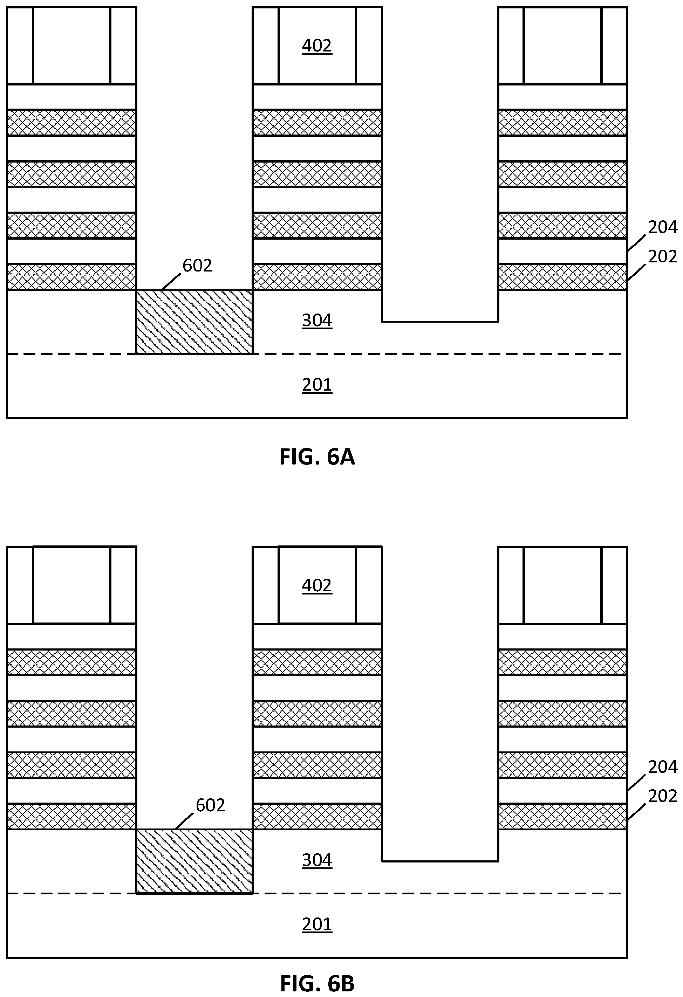

Figures 6A and 6B depict cross-section views of the structures shown in Figures 5A and 5B following the formation of sacrificial plugs 602 within the bottom of the source/drain trenches that extend through at least the entire thickness of subfin regions 304, according to some embodiments. Sacrificial plugs 602 may include any suitable material that can be safely removed at a later time without damaging surrounding materials (e.g., semiconductor and dielectric materials). In some examples, sacrificial plugs 602 include titanium nitride or aluminum oxide. The sacrificial material may be deposited and subsequently recessed using a suitable isotropic etching process to form sacrificial plugs 602 with a top surface substantially coplanar with a top surface of subfin regions 304. Any portions of the sacrificial material within the shallower recesses (e.g., righthand recesses) may be removed via suitable masking and etching techniques.

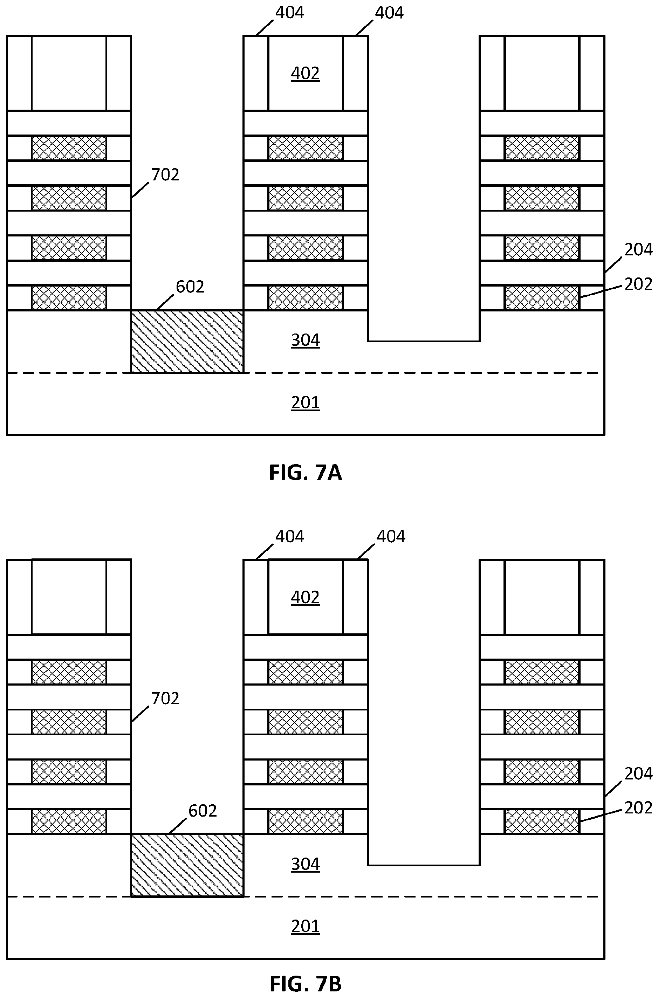

Figures 7A and 7B depict cross-section views of the structures shown in Figures 6A and 6B following the removal of portions of sacrificial layers 202 and formation of inner spacers 702 within the lateral recesses, according to an embodiment of the present disclosure. An isotropic etching process may be used to selectively recess the exposed ends of each sacrificial layer 202 (e.g., while etching comparatively little of semiconductor layers 204).

Inner spacers 702 may have a material composition that is similar to or the exact same as spacer structures 404. Accordingly, inner spacers 702 may be any suitable dielectric material that exhibits high etch selectively to semiconductor materials such as silicon and/or silicon germanium. Inner spacers 702 may be, for example, conformally deposited over the sides of the fin structure using a conformal deposition process like CVD or ALD and then etched back using an isotropic etching process to expose the ends of semiconductor layers 204. According to some embodiments, inner spacers 702 have a similar width (e.g., along the first direction) to spacer structures 404.

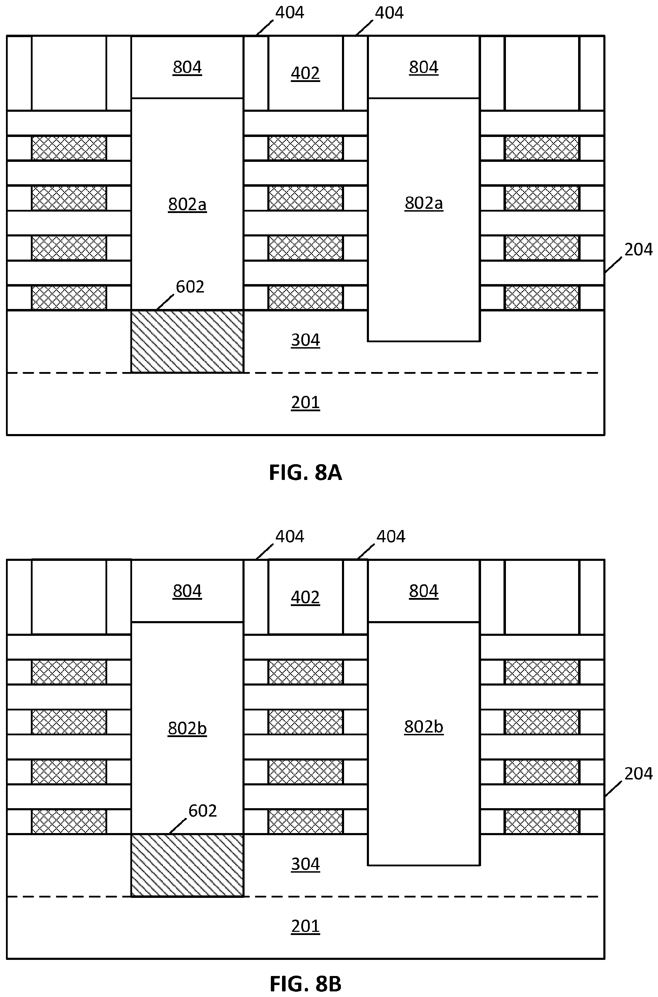

Figures 8A and 8B depict cross-section views of the structure shown in Figures 7A and 7B, respectively, following the formation of first source or drain regions 802a and second source or drain regions 802b within the source/drain trenches, according to some embodiments. Source or drain regions 802a/802b may be formed in the areas that had been previously occupied by the exposed fins between spacer structures 404. According to some embodiments, source or drain regions 802a/802b are epitaxially grown from the exposed semiconductor material at the ends of semiconductor layers 204. In some example embodiments, first source or drain regions 802a are n-type source or drain regions (e.g., epitaxial silicon with n-type dopants) and second source or drain regions 802b are p-type source or drain regions (e.g., epitaxial silicon germanium with p-type dopants).

According to some embodiments, a dielectric fill 804 is provided over source or drain regions 802a/802b. In some examples, dielectric fill 804 occupies a remaining volume within the source/drain trenches around and over portions of source or drain regions 802a/802b. Dielectric fill 804 may be any suitable dielectric material, such as silicon dioxide. In some examples, dielectric fill 804 extends up to and planar with a top surface of spacer structures 404 (e.g., following a polishing procedure).

According to some embodiments, source or drain regions 802a/802b that are to have backside contacts are formed directly on sacrificial plugs 602, as illustrated by the lefthand source or drain regions 802a/802b. In some embodiments, source or drain regions 802a/802b that are to not have backside contacts extend into at least a portion of subfin regions 304, as illustrated by the righthand source or drain regions 802a/802b.

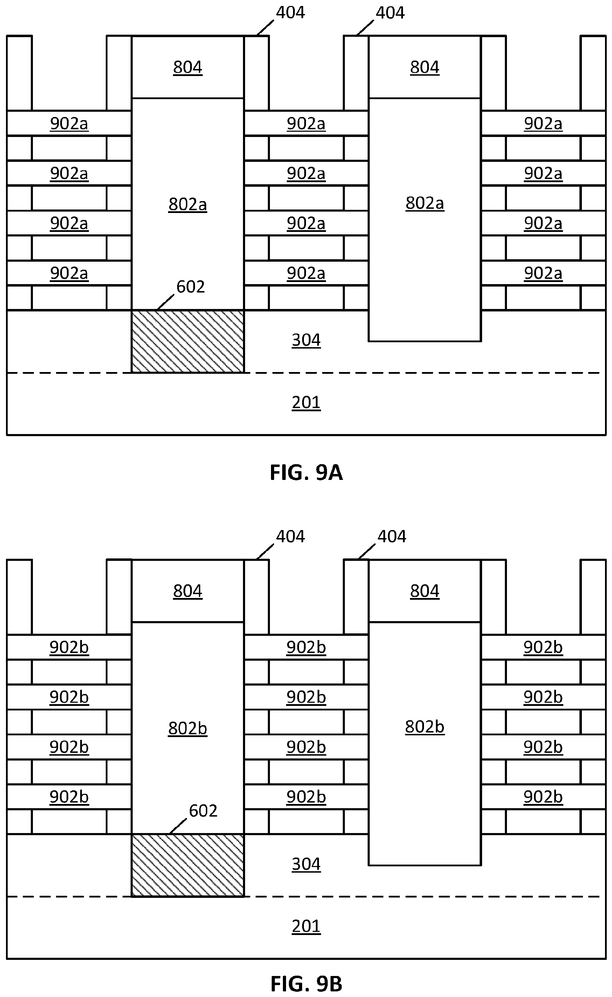

Figures 9A and 9B depict cross-section views of the structure shown in Figures 8A and 8B, respectively, following the removal of sacrificial gates 402 and sacrificial layers 202, according to some embodiments. In examples where gate masking layers are still present, they may be removed at this time. Once sacrificial gates 402 are removed, the remaining fin portions extending between spacer structures 404 are exposed.

In the example where the fins include alternating sacrificial layers 202 and semiconductor layers 204, sacrificial layers 202 are selectively removed to leave behind nanoribbons 902a extending between first source or drain regions 802a and nanoribbons 902b extending between second source or drain regions 802b. Each vertical set of nanoribbons 902a/902b represents the semiconductor region (also called channel region) of a different semiconductor device. It should be understood that nanoribbons 902a/902b may also be nanowires or nanosheets. Sacrificial gates 402 and sacrificial layers 202 may be removed using the same isotropic etching process or different isotropic etching processes.

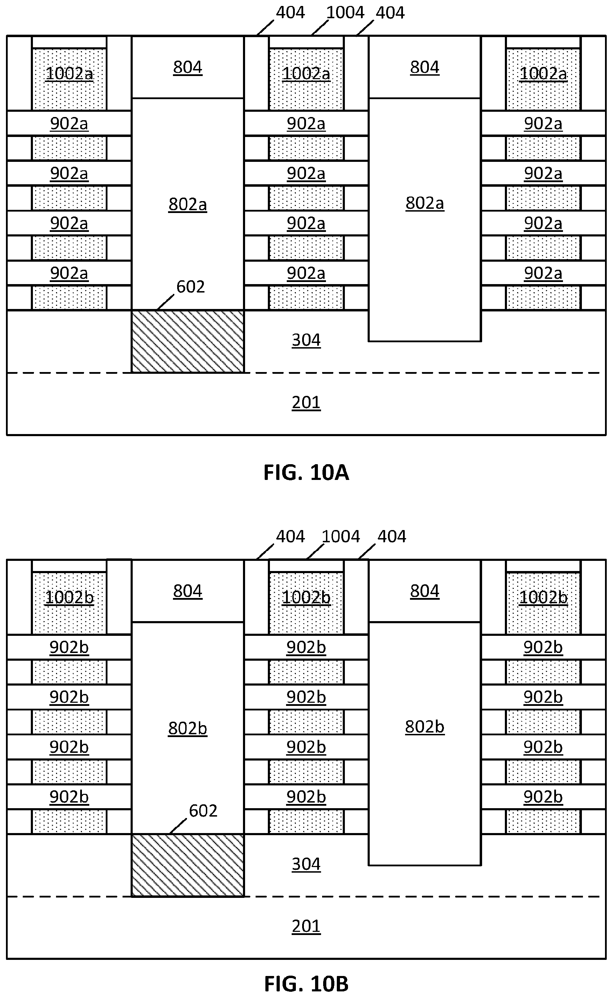

Figures 10A and 10B depict cross-section views of the structure shown in Figures 9A and 9B, respectively, following the formation of first gate structures 1002a around the suspended nanoribbons 902a and second gate structures 1002b around the suspended nanoribbons 902b, according to an embodiment of the present disclosure. As noted above, gate structures 1002a/1002b each include a gate dielectric and a gate electrode.

The gate dielectric may be conformally deposited around nanoribbons 902a/902b using any suitable deposition process, such as ALD. The gate dielectric may include any suitable dielectric (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, the gate dielectric is hafnium oxide with a thickness between about 1 nm and about 5 nm. In some embodiments, the gate dielectric may include one or more silicates (e.g., titanium silicate, tungsten silicate, niobium silicate, and silicates of other transition metals). The gate dielectric may be a multilayer structure, in some examples. For instance, the gate dielectric may include a first layer on nanoribbons 902a/902b, and a second layer on the first layer. The first layer can be, for instance, an oxide of the semiconductor layers (e.g., silicon dioxide) and the second layer can be a high-k dielectric material (e.g., hafnium oxide). In some embodiments, an annealing process may be carried out on the gate dielectric to improve its quality when a high-k dielectric material is used. In some embodiments, the high-k material can be nitridized to improve its aging resistance.

The gate electrode may be deposited over the gate dielectric and can be any standard or proprietary conductive material that may include any number of gate cuts. In some embodiments, the gate electrode includes doped polysilicon, a metal, or a metal alloy. Example suitable metals or metal alloys include aluminum, tungsten, cobalt, molybdenum, ruthenium, titanium, tantalum, copper, and carbides and nitrides thereof. The gate electrode may include, for instance, one or more workfunction layers, resistance-reducing layers, and/or barrier layers. In an example, first gate structures 1002a include n-type workfunction materials such as, for example, tungsten or titanium aluminum carbide. In an example, second gate structures 1002b include p-type workfunction materials such as titanium nitride.

According to some embodiments, a top portion of the gate electrode may be recessed within the gate trench. The recessed area may be filled with a dielectric material to form a gate cap 1004. According to some embodiments, gate cap 1004 includes any suitable dielectric material, such as silicon nitride or silicon oxynitride. In some examples, gate cap 1004 includes the same dielectric material as spacer structures 404.

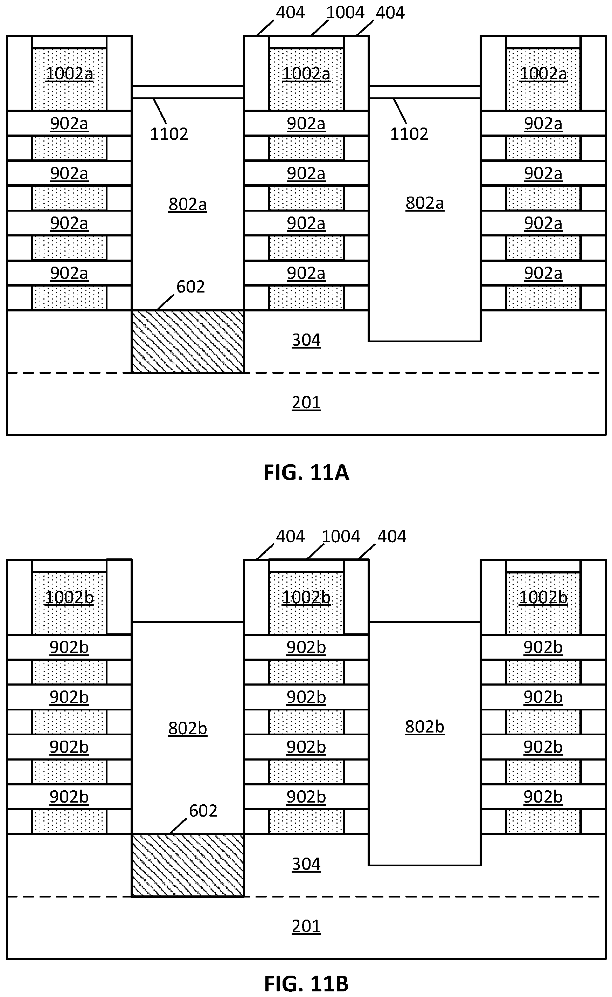

Figures 11A and 11B depict cross-section views of the structure shown in Figures 10A and 10B, respectively, following the removal of dielectric fill 804 over source or drain regions 802a/802b and subsequent formation of a first conductive layer 1102 over first source or drain regions 802a, according to some embodiments. Dielectric fill 804 may be removed using any suitable isotropic etching process to reveal a top surface of source or drain regions 802a/802b.

According to some embodiments, first conductive layer 1102 is formed on the top surface of first source or drain regions 802a but not on second source or drain regions 802b. This may be performed by masking second source or drain regions 802b (e.g., CHM) during the formation of first conductive layer 1102, or by forming first conductive layer 1102 over both source or drain regions 802a/802b and subsequently removing the layer from over the second source or drain regions 802b. First conductive layer 1102 may include, for instance, a silicide or germanide or group III-V-ide material or may include phosphorous-doped titanium, according to some examples.

According to some embodiments, first conductive layer 1102 may be deposited using CVD, ALD, or PVD, such as a sputtering process, to provide a more directional deposition of the conductive material. Accordingly, little of first conductive layer 1102 may form on the sidewalls of spacer structures 404. It should be understood that first conductive layer 1102 may also form along the top surfaces of gate cap 1004 and spacer structures 404, but that this portion of the layer can be later removed using any suitable polishing technique.

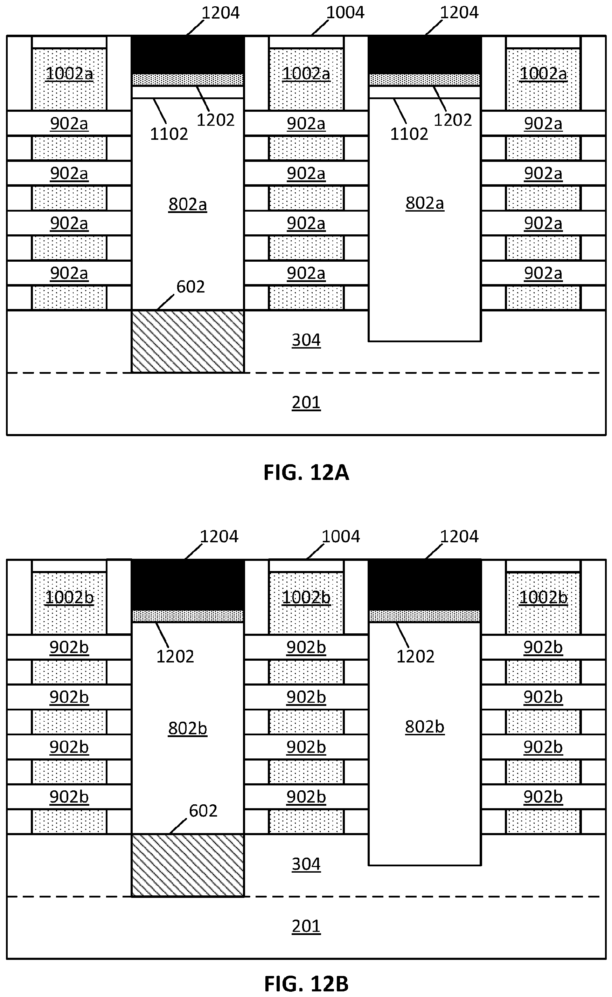

Figures 12A and 12B depict cross-section views of the structure shown in Figures 11A and 11B, respectively, following the formation of a second conductive layer 1202 over both source or drain regions 802a/802b and subsequent formation of topside contacts 1204, according to some embodiments. Second conductive layer 1202 may include a metal, such as molybdenum, although other metals can be used as well (e.g., ruthenium, cobalt, tungsten). According to some embodiments, second conductive layer 1202 is formed on a top surface of first conductive layer 1102 above first source or drain regions 802a and on a top surface of the second source or drain regions 802b. Similar to first conductive layer 1102, second conductive layer 1202 may be deposited using ALD, CVD, or PVD to facilitate higher directionality and less sidewall deposition.

Topside contacts 1204 may substantially fill any remaining volume within the source/drain trenches above second conductive layer 1202, according to some embodiments. A top surface of topside contacts 1204 may be polished using, for example, chemical mechanical polishing (CMP) until it is substantially coplanar with a top surface of gate cap 1004 and/or spacer structures 404. Topside contacts 1204 may include any suitable conductive material such as tungsten, ruthenium, molybdenum, or cobalt.

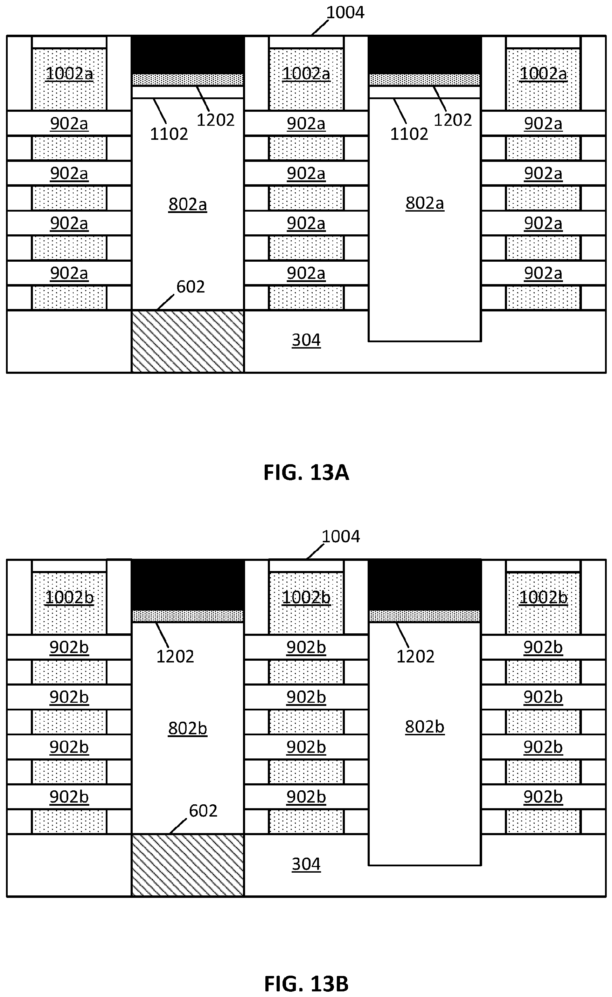

Figures 13A and 13B depict cross-section views of the structure shown in Figures 12A and 12B, respectively, following the removal of a backside portion of substrate 201, according to some embodiments. Any number of polishing, grinding, or etching processes (e.g., CMP) may be used to remove the bulk portion of substrate 201. According to some embodiments, substrate 201 is removed until a bottom surface of subfin regions 304 and/or the dielectric layer adjacent to the subfin regions is exposed. According to some embodiments, a bottom surface of sacrificial plugs 602 is exposed by removing substrate 201.

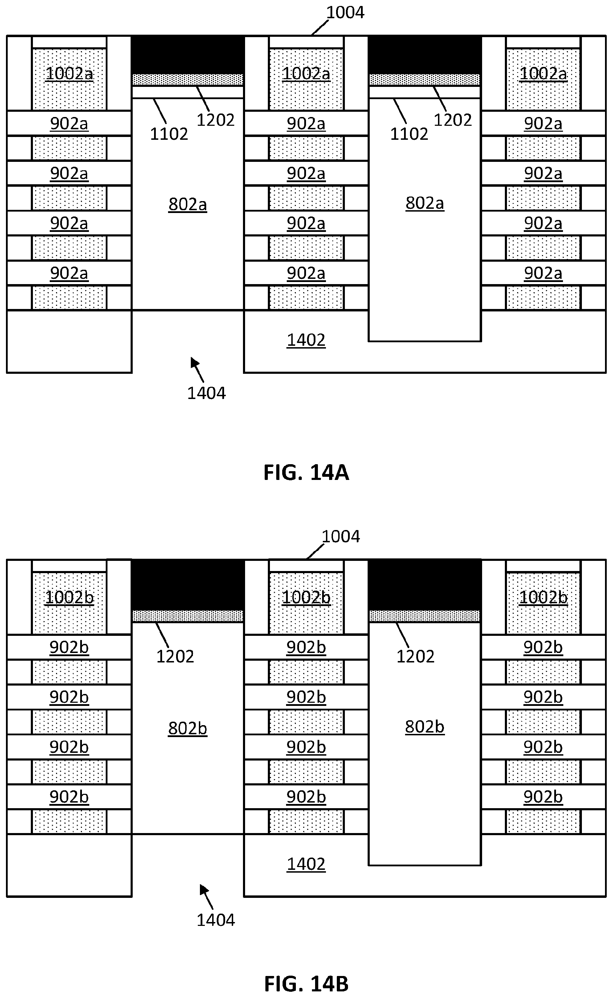

Figures 14A and 14B depict cross-section views of the structure shown in Figures 13A and 13B, respectively, following the replacement of subfin regions 304 with a base dielectric structure 1402 and the removal of sacrificial plugs 602, according to some embodiments. Subfin regions 304 may be removed using a suitable isotropic etching process followed by the backside formation of base dielectric structure 1402. According to some embodiments, base dielectric structure 1402 includes any number of dielectric layers. In some examples, base dielectric structure 1402 includes a layer of silicon dioxide. Base dielectric layer may be polished such that a bottom surface of base dielectric structure 1402 is substantially coplanar with a bottom surface of sacrificial plugs 602. Another isotropic etching process may be used to selectively remove sacrificial plugs 602 leaving backside cavities 1404 through an entire thickness of base dielectric structure 1402. According to some embodiments, a bottom surface of source or drain regions 802a/802b is exposed within backside cavities 1404.

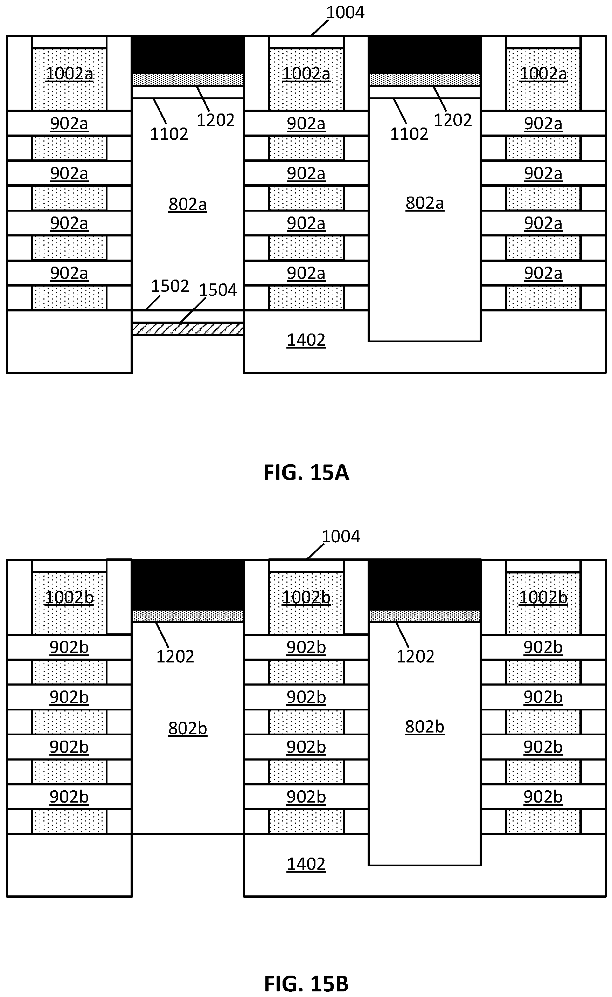

Figures 15A and 15B depict cross-section views of the structure shown in Figures 14A and 14B, respectively, following the backside formation of a third conductive layer 1502 on a bottom surface of the first source or drain region 802a and a fourth conductive layer 1504 on third conductive layer 1502. According to some embodiments, third conductive layer 1502 and fourth conductive layer 1504 are formed on the bottom surface of first source or drain region 802a but not on the bottom of second source or drain region 802b. This may be performed by masking second source or drain region 802b during the formation of third conductive layer 1502 and fourth conductive layer 1504 (e.g., CHM), or by forming third conductive layer 1502 and fourth conductive layer 1504 beneath both source or drain regions 802a/802b and subsequently removing the layer from beneath the second source or drain regions 802b.

Third conductive layer 1502 may include, for instance, a silicide, germanide, or group III-V-ide material, or may include phosphorous-doped titanium. According to some embodiments, fourth conductive layer 1504 includes scandium. Like the topside conductive layers, third conductive layer 1502 and fourth conductive layer 1504 may be deposited using ALD, CVD, or PVD to reduce or eliminate sidewall deposition. Third conductive layer 1502 may be deposited to a thickness, for example, between about 2 nm and about 6 nm, and fourth conductive layer 1504 may be deposited to a thickness, for example, between about 1 nm and about 5 nm.

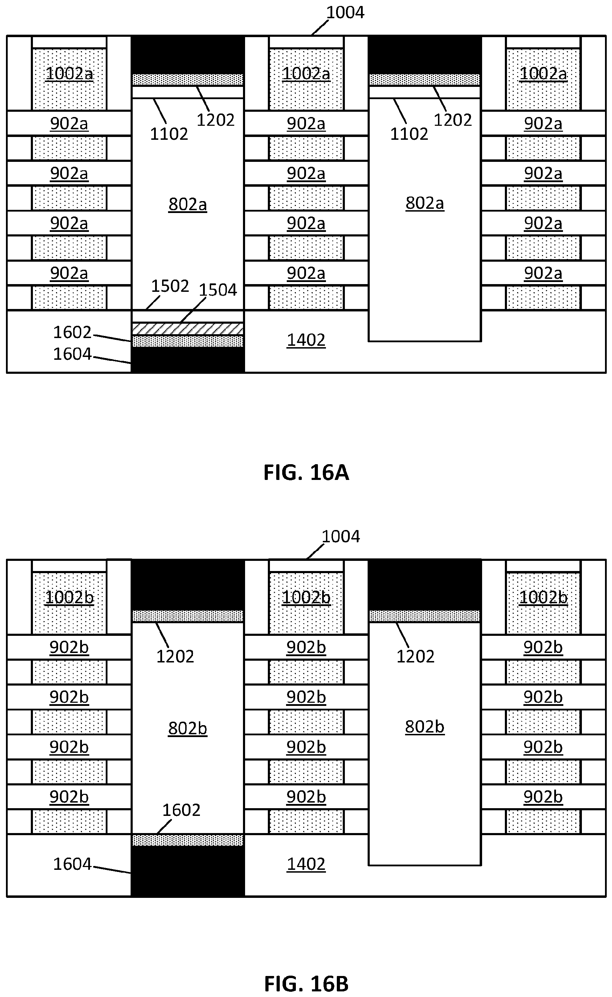

Figures 16A and 16B depict cross-section views of the structure shown in Figures 15A and 15B, respectively, following the formation of a fifth conductive layer 1602 beneath both source or drain regions 802a/802b and subsequent formation of backside contacts 1604, according to some embodiments. Fifth conductive layer 1602 may include a metal, such as molybdenum, although other metals can be used as well (e.g., cobalt, ruthenium, tungsten). According to some embodiments, fifth conductive layer 1602 is formed on a bottom surface of fourth conductive layer 1504 below first source or drain regions 802a and on a bottom surface of the second source or drain regions 802b. As discussed above, fifth conductive layer 1602 may be deposited using ALD, CVD, or PVD to facilitate higher directionality and less sidewall deposition.

Backside contacts 1604 may substantially fill any remaining volume within the backside cavities 1404 below fifth conductive layer 1602, according to some embodiments. A bottom surface of backside contacts 1604 may be polished using, for example, CMP until it is substantially coplanar with a bottom surface of base dielectric structure 1402. Backside contacts 1604 may include any suitable conductive material such as tungsten, ruthenium, molybdenum, or cobalt.

Figures 17A and 17B depict cross-section views of the structure shown in Figures 16A and 16B, respectively, following the formation of a backside conductive trace 1702 through a backside dielectric layer 1704, according to some embodiments. Backside dielectric layer 1704 may include any suitable dielectric material, such as silicon dioxide. In some examples, backside dielectric layer 1704 includes the same dielectric material as base dielectric structure 1402. Backside conductive trace 1702 may be formed across a bottom surface of backside contacts 1604 to provide power or signal to the backside of source or drain regions 802a/802b. In some examples, backside conductive trace 1702 is an interconnect structure that is part of a backside interconnect region having any number of backside interconnect layers for routing signal and/or power to/from any number of semiconductor devices.

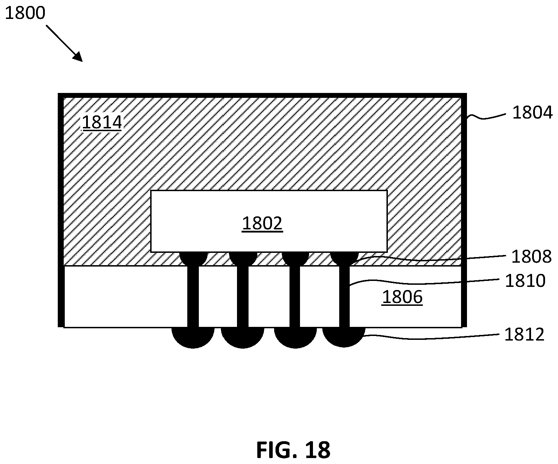

Figure 18 illustrates an example embodiment of a chip package 1800, in accordance with an embodiment of the present disclosure. As can be seen, chip package 1800 includes one or more dies 1802. One or more dies 1802 may include at least one integrated circuit having semiconductor devices, such as any of the semiconductor devices disclosed herein. One or more dies 1802 may include any other circuitry used to interface with other devices formed on the dies, or other devices connected to chip package 1800, in some example configurations.

As can be further seen, chip package 1800 includes a housing 1804 that is bonded to a package substrate 1806. The housing 1804 may be any standard or proprietary housing, and may provide, for example, electromagnetic shielding and environmental protection for the components of chip package 1800. The one or more dies 1802 may be conductively coupled to a package substrate 1806 using connections 1808, which may be implemented with any number of standard or proprietary connection mechanisms, such as solder bumps, ball grid array (BGA), pins, or wire bonds, to name a few examples. Package substrate 1806 may be any standard or proprietary package substrate, but in some cases includes a dielectric material having conductive pathways (e.g., including conductive vias and lines) extending through the dielectric material between the faces of package substrate 1806, or between different locations on each face. In some embodiments, package substrate 1806 may have a thickness less than 1 millimeter (e.g., between 0.1 millimeters and 0.5 millimeters), although any number of package geometries can be used. Additional conductive contacts 1812 may be disposed at an opposite face of package substrate 1806 for conductively contacting, for instance, a printed circuit board (PCB). One or more vias 1810 extend through a thickness of package substrate 1806 to provide conductive pathways between one or more of connections 1808 to one or more of contacts 1812. Vias 1810 are illustrated as single straight columns through package substrate 1806 for ease of illustration, although other configurations can be used (e.g., damascene, dual damascene, through-silicon via, or an interconnect structure that meanders through the thickness of substrate 1806 to contact one or more intermediate locations therein). In still other embodiments, vias 1810 are fabricated by multiple smaller stacked vias, or are staggered at different locations across package substrate 1806. In the illustrated embodiment, contacts 1812 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 1812, to inhibit shorting.

In some embodiments, a mold material 1814 may be disposed around the one or more dies 1802 included within housing 1804 (e.g., between dies 1802 and package substrate 1806 as an underfill material, as well as between dies 1802 and housing 1804 as an overfill material). Although the dimensions and qualities of the mold material 1814 can vary from one embodiment to the next, in some embodiments, a thickness of mold material 1814 is less than 1 millimeter. Example materials that may be used for mold material 1814 include epoxy mold materials, as suitable. In some cases, the mold material 1814 is thermally conductive, in addition to being electrically insulating.

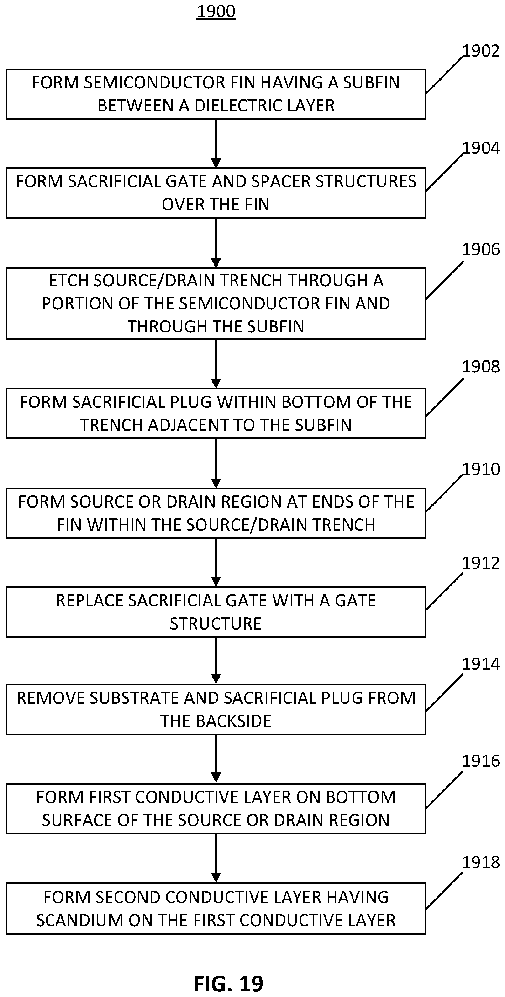

Figure 19 is a flow chart of a method 1900 for forming at least a portion of an integrated circuit, according to an embodiment. Various operations of method 1900 may be illustrated in Figures 2A - 17A and 2B - 17B. However, the correlation of the various operations of method 1900 to the specific components illustrated in the aforementioned figures is not intended to imply any structural and/or use limitations. Rather, the aforementioned figures provide one example embodiment of method 1900. Other operations may be performed before, during, or after any of the operations of method 1900. For example, method 1900 does not explicitly describe various standard processes that are usually performed to form transistor structures. Some of the operations of method 1900 may be performed in a different order than the illustrated order.

Method 1900 begins with operation 1902 where at least one semiconductor fin is formed, according to some embodiments. The semiconductor material in the fin may be formed from a substrate such that the fin is an integral part of the substrate (e.g., etched from a bulk silicon substrate). Alternatively, the fin can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fin includes alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around (GAA) process can then be carried out. Again, the alternating layers can be blanket deposited and then etched into fins, or deposited into fin-shaped trenches. The fin may also include a cap structure over its top surface that is used to define the location of the fin during, for example, an RIE process. The cap structure may be a dielectric material, such as silicon nitride.

According to some embodiments, a dielectric layer is formed around a subfin portion of the fin. In some examples, the anisotropic etching process used to from the fin continues into at least a portion of the underlying substrate. The etched portions of the substrate that are not under any fins may be filled with a dielectric fill to form the dielectric layer that acts as STI between adjacent fins. The dielectric layer may be any suitable dielectric material such as silicon dioxide. The subfin represents a remaining portion of the substrate flanked by the dielectric layer beneath the fin, according to some embodiments.

Method 1900 continues with operation 1904 where a sacrificial gate is formed over the fin. Any number of sacrificial gates may be patterned using gate masking layers in strips that run orthogonally over the fins and parallel to one another (e.g., forming a cross-hatch pattern). The gate masking layers may be any suitable hard mask material, such as CHM or silicon nitride. The sacrificial gates themselves may be formed from any suitable material that can be selectively removed at a later time without damaging the semiconductor material of the fins. In one example, the sacrificial gates include polysilicon.

According to some embodiments, spacer structures are also formed on sidewalls of at least the sacrificial gates. The spacer structures may be deposited and then etched back such that the spacer structures remain mostly only on sidewalls of any exposed structures. In some cases, spacer structures may also be formed along sidewalls of the exposed fins running orthogonally between the strips of sacrificial gates. According to some embodiments, the spacer structures may be any suitable dielectric material, such as silicon nitride or silicon oxynitride.

Method 1900 continues with operation 1906 where portions of the fin adjacent to the sacrificial gate and spacer structures (e.g., not covered by the sacrificial gate and spacer structures) are removed. Any exposed portions of the fin not covered by the sacrificial gate or spacer structures may be removed using any anisotropic etching process, such as RIE. According to some embodiments, the etch continues past the height of the fin into the subfin such that a recess is etched into the subfin (and possibly further into the bulk substrate) adjacent to the remaining portion of the fin.

Method 1900 continues with operation 1908, where a sacrificial plug is formed within the bottom of the recess. According to some embodiments, a sacrificial material is deposited over the entire structure and recessed using any suitable isotropic etching process until the material remains only within the recess etched into the substrate material. The sacrificial material may include any suitable material that can be safely removed at a later time, such as titanium nitride or aluminum oxide.

Method 1900 continues with operation 1910 where source or drain regions are formed at the exposed ends of the fin. The source or drain regions may be formed in the areas that had been previously occupied by the exposed fin between the spacer structures. According to some embodiments, the source or drain regions are epitaxially grown from the exposed semiconductor material of the fin (or nanoribbons, nanowires or nanosheets, as the case may be) along the exterior walls of the spacer structures. In some example embodiments, the source or drain regions are NMOS source or drain regions (e.g., epitaxial silicon). A dielectric fill may formed between and over the source or drain regions along a given source/drain trench. The dielectric fill may be any suitable dielectric material, such as silicon dioxide. In some examples, the dielectric fill extends over the source or drain regions up to and planar with a top surface of the spacer structures. The dielectric fill also acts as an electrical insulator between adjacent source or drain regions, although some adjacent source or drain regions may have merged together during their growth. According to some embodiments, a given source or drain region is grown directly over the sacrificial plug, such that a bottom surface of the given source or drain region may contact a top surface of the sacrificial plug.

Method 1900 continues with operation 1912 where a gate structure is formed over the semiconductor material of the semiconductor fin. The sacrificial gate is first removed along with any sacrificial layers within the exposed fin between the spacer structures (in the case of GAA structures). The gate structure may then be formed in place of the sacrificial gate. The gate structure may each include both a gate dielectric and a gate electrode. The gate dielectric is first formed over the exposed semiconductor regions between the spacer structures followed by forming the gate electrode within the remainder of the trench between the spacer structures, according to some embodiments. The gate dielectric may include any number of dielectric layers deposited using a CVD process, such as ALD. The gate electrode can include any conductive material, such as a metal, metal alloy, or polysilicon. The gate electrode may be deposited using electroplating, electroless plating, CVD, ALD, PECVD, or PVD, to name a few examples.

Method 1900 continues with operation 1914 where the substrate is removed from the backside of the structure. The substrate may be removed via any combination of grinding, polishing, and/or etching processes. In some embodiments, the substrate is thinned away at least until a bottom surface of the sacrificial plug is exposed. In some examples, the only portions of the semiconductor material from the substrate left behind following the backside polishing process are the subfins. According to some embodiments, the subfins may be removed via a suitable isotropic etching process and replaced with one or more dielectric layers. According to some embodiments, the sacrificial plug may also be removed to form a backside cavity beneath the given source or drain region, such that a bottom surface of the given source or drain region is exposed. The sacrificial plug may be removed using any suitable isotropic etching process that removes the sacrificial material but removes none, or very little, of any exposed dielectric, metal, or semiconductor material.

Method 1900 continues with operation 1916 where a first conductive layer is formed on the bottom surface of the exposed source or drain region within the backside cavity. According to some embodiments, the first conductive layer is one layer of a backside contact structure. The first conductive layer may include, for instance, a silicide, germanide, or group III-V-ide material, or may include phosphorous-doped titanium. According to some embodiments, the first conductive layer may be deposited using ALD, CVD, or PVD to reduce or eliminate deposition of the material on the sidewalls of the backside cavity. The first conductive layer may be, for example, deposited to a thickness between about 2 nm and about 6 nm.

Method 1900 continues with operation 1918 where a second conductive layer is formed on the bottom surface of the first conductive layer within the backside cavity. According to some embodiments, the second conductive layer is another layer of the backside contact structure. According to some embodiments, the second conductive layer includes scandium. The second conductive layer may be deposited using ALD, CVD, or PVD to reduce or eliminate deposition of the material on the sidewalls of the backside cavity. The second conductive layer may be deposited to a thickness, for example, between about 1 nm and about 5 nm. Additional conductive layers may be formed beneath the second conductive layer to complete the formation of the backside contact structure. For example, a layer of molybdenum may be formed on the bottom surface of the second conductive layer, followed by a conductive fill that includes a suitable metal such as tungsten, ruthenium, molybdenum, or cobalt.

### Example System

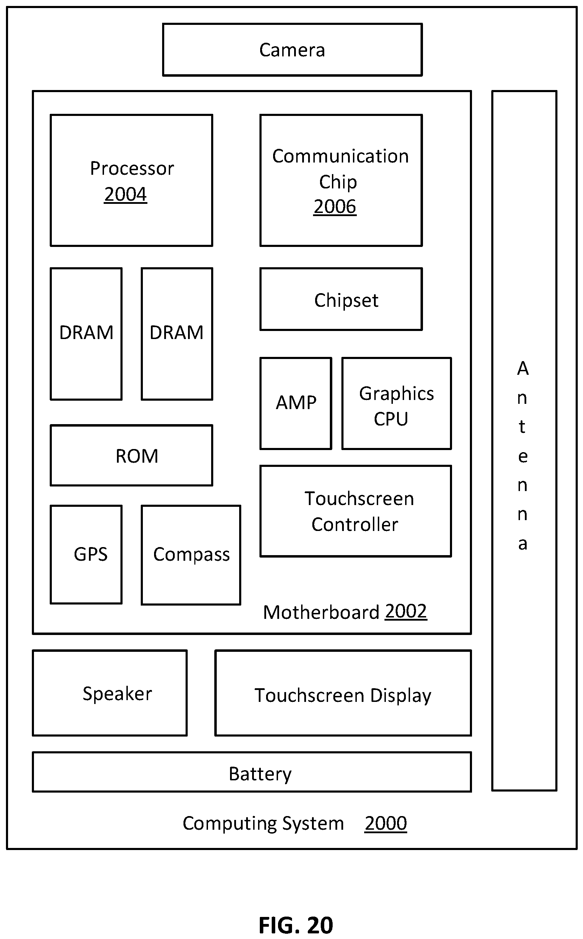

FIG. 20 is an example computing system implemented with one or more of the integrated circuit structures as disclosed herein, in accordance with some embodiments of the present disclosure. As can be seen, the computing system 2000 houses a motherboard 2002. The motherboard 2002 may include a number of components, including, but not limited to, a processor 2004 and at least one communication chip 2006, each of which can be physically and electrically coupled to the motherboard 2002, or otherwise integrated therein. As will be appreciated, the motherboard 2002 may be, for example, any printed circuit board (PCB), whether a main board, a daughterboard mounted on a main board, or the only board of system 2000, etc.

Depending on its applications, computing system 2000 may include one or more other components that may or may not be physically and electrically coupled to the motherboard 2002. These other components may include, but are not limited to, volatile memory (e.g., DRAM), nonvolatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 2000 may include one or more integrated circuit structures or devices configured in accordance with an example embodiment (e.g., a module including an integrated circuit configured with different semiconductor devices with different backside contact structures, as variously provided herein). At least one of the backside contact structures includes a conductive layer having scandium. In some embodiments, multiple functions can be integrated into one or more chips (e.g., for instance, note that the communication chip 2006 can be part of or otherwise integrated into the processor 2004).

The communication chip 2006 enables wireless communications for the transfer of data to and from the computing system 2000. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 2006 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 2000 may include a plurality of communication chips 2006. For instance, a first communication chip 2006 may be dedicated to shorter range wireless communications such as Wi-Fi and Bluetooth and a second communication chip 2006 may be dedicated to longer range wireless communications such as GPS, EDGE, GPRS, CDMA, WiMAX, LTE, Ev-DO, and others.

The processor 2004 of the computing system 2000 includes an integrated circuit die packaged within the processor 2004. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 2006 also may include an integrated circuit die packaged within the communication chip 2006. In accordance with some such example embodiments, the integrated circuit die of the communication chip includes one or more semiconductor devices as variously described herein. As will be appreciated in light of this disclosure, note that multistandard wireless capability may be integrated directly into the processor 2004 (e.g., where functionality of any chips 2006 is integrated into processor 2004, rather than having separate communication chips). Further note that processor 2004 may be a chip set having such wireless capability. In short, any number of processor 2004 and/or communication chips 2006 can be used. Likewise, any one chip or chip set can have multiple functions integrated therein.

In various implementations, the computing system 2000 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 2000 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a semiconductor device having a semiconductor region extending in a first direction from a source or drain region and a gate structure extending in a second direction over the semiconductor region, a dielectric layer beneath the gate structure, and a contact structure on a bottom surface of the source or drain region and adjacent to the dielectric layer. The contact structure includes a first conductive layer on the bottom surface of the source or drain region and a second conductive layer on the first conductive layer. The second conductive layer includes scandium.

Example 2 includes the integrated circuit of Example 1, wherein the first conductive layer comprises titanium and phosphorous.

Example 3 includes the integrated circuit of Example 1 or 2, wherein the source or drain region comprises silicon and phosphorous.

Example 4 includes the integrated circuit of any one of Examples 1-3, wherein the contact structure further comprises a third conductive layer on the second conductive layer, wherein the third conductive layer comprises molybdenum.

Example 5 includes the integrated circuit of any one of Examples 1-4, wherein the contact structure is a first contact structure and the integrated circuit further comprises a second contact structure on a top surface of the source or drain region.

Example 6 includes the integrated circuit of Example 5, wherein the second contact structure comprises a conductive layer having titanium and phosphorous.

Example 7 includes the integrated circuit of any one of Examples 1-6, further comprising a backside conductive trace below the dielectric layer and a conductive contact extending between the backside conductive trace and the contact structure.

Example 8 includes the integrated circuit of any one of Examples 1-7, wherein the semiconductor device is a first semiconductor device and the contact structure is a first contact structure. The integrated circuit further includes a second semiconductor device having a second semiconductor region extending in the first direction from a second source or drain region and a second gate structure extending in the second direction over the second semiconductor region, and a second contact structure on a bottom surface of the second source or drain region and adjacent to the dielectric layer. The second contact structure includes a conductive layer having molybdenum.

Example 9 includes the integrated circuit of Example 8, wherein the conductive layer is a third conductive layer, and the second contact structure further comprises a fourth conductive layer on the third conductive layer, the fourth conductive layer having titanium and boron.

Example 10 includes the integrated circuit of Example 8 or 9, wherein the first source or drain region is an n-type region and the second source or drain region is a p-type region.

Example 11 includes the integrated circuit of any one of Examples 1-10, wherein the semiconductor region comprises a plurality of semiconductor nanoribbons.

Example 12 includes the integrated circuit of Example 11, wherein the plurality of semiconductor nanoribbons comprise germanium, silicon, or a combination thereof.

Example 13 is a printed circuit board comprising the integrated circuit of any one of Examples 1-12.

Example 14 is an electronic device that includes a chip package having one or more dies. At least one of the one or more dies includes a semiconductor device having a semiconductor region extending in a first direction from a source or drain region and a gate structure extending in a second direction over the semiconductor region, a dielectric layer beneath the gate structure, and a contact structure on a bottom surface of the source or drain region and adjacent to the dielectric layer. The contact structure includes a first conductive layer on the bottom surface of the source or drain region and a second conductive layer on the first conductive layer. The second conductive layer includes scandium.

Example 15 includes the electronic device of Example 14, wherein the first conductive layer comprises titanium and phosphorous.

Example 16 includes the electronic device of Example 14 or 15, wherein the source or drain region comprises silicon and phosphorous.

Example 17 includes the electronic device of any one of Examples 14-16, wherein the contact structure further comprises a third conductive layer on the second conductive layer, wherein the third conductive layer comprises molybdenum.

Example 18 includes the electronic device of any one of Examples 14-17, wherein the contact structure is a first contact structure and the at least one of the one or more dies further comprises a second contact structure on a top surface of the source or drain region.

Example 19 includes the electronic device of Example 18, wherein the second contact structure comprises a conductive layer having titanium and phosphorous.

Example 20 includes the electronic device of any one of Examples 14-19, wherein the at least one of the one or more dies further comprises a backside conductive trace below the dielectric layer and a conductive contact extending between the backside conductive trace and the contact structure.

Example 21 includes the electronic device of any one of Examples 14-20, wherein the semiconductor device is a first semiconductor device and the contact structure is a first contact structure. The at least one of the one or more dies further includes a second semiconductor device having a second semiconductor region extending in the first direction from a second source or drain region and a second gate structure extending in the second direction over the second semiconductor region, and a second contact structure on a bottom surface of the second source or drain region and adjacent to the dielectric layer. The second contact structure includes a conductive layer having molybdenum.

Example 22 includes the electronic device of Example 21, wherein the conductive layer is a third conductive layer, and the second contact structure further comprises a fourth conductive layer on the third conductive layer, the fourth conductive layer having titanium and boron.

Example 23 includes the electronic device of Example 21 or 22, wherein the first source or drain region is an n-type region and the second source or drain region is a p-type region.

Example 24 includes the electronic device of any one of Examples 14-23, wherein the semiconductor region comprises a plurality of semiconductor nanoribbons.

Example 25 includes the electronic device of Example 24, wherein the plurality of semiconductor nanoribbons comprises germanium, silicon, or a combination thereof.

Example 26 includes the electronic device of any one of Examples 14-25, further comprising a printed circuit board, wherein the chip package is coupled to the printed circuit board.

Example 27 is a method of forming an integrated circuit. The method includes forming a fin comprising semiconductor material, the fin extending above a substrate; forming a dielectric layer adjacent to a subfin of the fin; forming sacrificial gates and spacer structures over the fin; removing portions of the fin not covered by the sacrificial gates and spacer structures; removing a portion of the subfin to form a subfin recess; forming a sacrificial plug within the subfin recess; forming a source or drain region at exposed ends of the semiconductor material above the sacrificial plug; removing the substrate to expose a backside of the sacrificial plug; removing the sacrificial plug from the backside; forming a first conductive layer on a bottom surface of the source or drain region; forming a second conductive layer on the first conductive layer, wherein the second conductive layer comprises scandium; and forming a conductive contact beneath the second conductive layer.

Example 28 includes the method of Example 27, wherein forming the first conductive layer comprises forming a layer comprising titanium and phosphorous.

Example 29 includes the method of Example 27 or 28, further comprising removing a remaining portion of the subfin from the backside; and forming a dielectric fill in place of the remaining portion of the subfin.

Example 30 includes the method of Example 29, further comprising forming a conductive trace beneath the dielectric fill, such that the conductive contact is coupled to the conductive trace.

Example 31 includes the method of any one of Examples 27-30, further comprising replacing the sacrificial gate with a gate structure over the semiconductor material.

Example 32 includes the method of any one of Examples 27-31, wherein forming the source or drain region comprises epitaxially growing silicon doped with phosphorous.

Example 33 is an integrated circuit that includes a first semiconductor device having a first semiconductor region extending in a first direction from a first source or drain region and a first gate structure extending in a second direction over the first semiconductor region, a second semiconductor device having a second semiconductor region extending in the first direction from a second source or drain region and a second gate structure extending in the second direction over the second semiconductor region, a dielectric layer beneath the first and second gate structures, a first contact structure on a bottom surface of the first source or drain region and adjacent to the dielectric layer, and a second contact structure on a bottom surface of the second source or drain region and adjacent to the dielectric layer. The first contact structure includes a first conductive layer comprising scandium, and the second contact structure includes a second conductive layer comprising molybdenum.

Example 34 includes the integrated circuit of Example 33, wherein the first contact structure comprises a third conductive layer comprising titanium and phosphorous.

Example 35 includes the integrated circuit of Example 34, wherein the first contact structure comprises a fourth conductive layer comprising molybdenum.

Example 36 includes the integrated circuit of any one of Examples 33-35, wherein the first source or drain region comprises silicon and phosphorous and the second source or drain region comprises silicon, germanium, and boron.

Example 37 includes the integrated circuit of any one of Examples 33-36, wherein the second contact structure further comprises a third conductive layer comprising titanium and boron.

Example 38 includes the integrated circuit of any one of Examples 33-37, further comprising a third contact structure on a top surface of the first source or drain region and a fourth contact structure on a top surface of the second source or drain region.

Example 39 includes the integrated circuit of Example 38, wherein the third contact structure comprises a third conductive layer having titanium and phosphorous.

Example 40 includes the integrated circuit of Example 38 or 39, wherein the fourth contact structure comprises a third conductive layer having molybdenum.

Example 41 includes the integrated circuit of any one of Examples 33-40, further comprising a backside conductive trace below the dielectric layer and a conductive contact extending between the backside conductive trace and the first contact structure or the second contact structure.

Example 42 includes the integrated circuit of any one of Examples 33-41, wherein the first source or drain region is an n-type region and the second source or drain region is a p-type region.

Example 43 includes the integrated circuit of any one of Examples 33-42, wherein the first semiconductor region comprises a first plurality of semiconductor nanoribbons and the second semiconductor region comprises a second plurality of semiconductor nanoribbons.

Example 44 includes the integrated circuit of Example 43, wherein the first plurality of semiconductor nanoribbons and second plurality of semiconductor nanoribbons comprise germanium, silicon, or a combination thereof.

Example 45 is a printed circuit board comprising the integrated circuit of any one of Examples 33-44.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

The following section of the description relates to further examples. The numbered paragraphs in this section are not claims. The claims are set forth below in the later section headed "claims".
1. An integrated circuit comprising: a semiconductor device having a semiconductor region extending in a first direction from a source or drain region, and a gate structure extending in a second direction over the semiconductor region; a dielectric layer beneath the gate structure; and a contact structure on a bottom surface of the source or drain region and adjacent to the dielectric layer, the contact structure comprising a first conductive layer on the bottom surface of the source or drain region, and a second conductive layer on the first conductive layer, wherein the second conductive layer comprises scandium.
2. The integrated circuit of clause 1, wherein the first conductive layer comprises titanium and phosphorous.
3. The integrated circuit of clause 1, wherein the contact structure further comprises a third conductive layer on the second conductive layer, wherein the third conductive layer comprises molybdenum.
4. The integrated circuit of clause 1, wherein the contact structure is a first contact structure and the integrated circuit further comprises a second contact structure on a top surface of the source or drain region.
5. The integrated circuit of clause 4, wherein the second contact structure comprises a conductive layer having titanium and phosphorous.
6. The integrated circuit of clause 1, further comprising a backside conductive trace below the dielectric layer and a conductive contact extending between the backside conductive trace and the contact structure.
7. The integrated circuit of clause 1, wherein the semiconductor device is a first semiconductor device and the contact structure is a first contact structure, the integrated circuit further comprising: a second semiconductor device having a second semiconductor region extending in the first direction from a second source or drain region, and a second gate structure extending in the second direction over the second semiconductor region; and a second contact structure on a bottom surface of the second source or drain region and adjacent to the dielectric layer, the second contact structure comprising a conductive layer having molybdenum.
8. The integrated circuit of clause 7, wherein the first source or drain region is an n-type region and the second source or drain region is a p-type region.
9. A printed circuit board comprising the integrated circuit of clause 1.
10. An electronic device, comprising: a chip package comprising one or more dies, at least one of the one or more dies comprising a semiconductor device having a semiconductor region extending in a first direction from a source or drain region, and a gate structure extending in a second direction over the semiconductor region; a dielectric layer beneath the gate structure; and a contact structure on a bottom surface of the source or drain region and adjacent to the dielectric layer, the contact structure comprising a first conductive layer on the bottom surface of the source or drain region, and a second conductive layer on the first conductive layer, wherein the second conductive layer comprises scandium.
11. The electronic device of clause 10, wherein the contact structure is a first contact structure and the at least one of the one or more dies further comprises a second contact structure on a top surface of the source or drain region.
12. The electronic device of clause 11, wherein the second contact structure comprises a conductive layer having titanium and phosphorous.
13. The electronic device of clause 10, wherein the semiconductor device is a first semiconductor device and the contact structure is a first contact structure, the at least one of the one or more dies further comprising: a second semiconductor device having a second semiconductor region extending in the first direction from a second source or drain region, and a second gate structure extending in the second direction over the second semiconductor region; and a second contact structure on a bottom surface of the second source or drain region and adjacent to the dielectric layer, the second contact structure comprising a third conductive layer having molybdenum.
14. The electronic device of clause 13, wherein the second contact structure further comprises a fourth conductive layer on the third conductive layer, the fourth conductive layer having titanium and boron.
15. An integrated circuit comprising: a first semiconductor device having a first semiconductor region extending in a first direction from a first source or drain region, and a first gate structure extending in a second direction over the first semiconductor region; a second semiconductor device having a second semiconductor region extending in the first direction from a second source or drain region, and a second gate structure extending in the second direction over the second semiconductor region; a dielectric layer beneath the first and second gate structures; a first contact structure on a bottom surface of the first source or drain region and adjacent to the dielectric layer, the first contact structure comprising a first conductive layer comprising scandium; and a second contact structure on a bottom surface of the second source or drain region and adjacent to the dielectric layer, the second contact structure comprising a second conductive layer comprising molybdenum.
16. The integrated circuit of clause 15, wherein the first contact structure comprises a third conductive layer comprising titanium and phosphorous.
17. The integrated circuit of clause 16, wherein the first contact structure comprises a fourth conductive layer comprising molybdenum.
18. The integrated circuit of clause 15, wherein the first source or drain region comprises silicon and phosphorous and the second source or drain region comprises silicon, germanium, and boron.
19. The integrated circuit of clause 15, wherein the second contact structure further comprises a third conductive layer comprising titanium and boron.
20. The integrated circuit of clause 15, wherein the first source or drain region is an n-type region and the second source or drain region is a p-type region.

## Claims

1. An integrated circuit comprising:
a semiconductor device having a semiconductor region extending in a first direction from a source or drain region, and a gate structure extending in a second direction over the semiconductor region;
a dielectric layer beneath the gate structure; and
a contact structure on a bottom surface of the source or drain region and adjacent to the dielectric layer, the contact structure comprising
a first conductive layer on the bottom surface of the source or drain region, and
a second conductive layer on the first conductive layer, wherein the second conductive layer comprises scandium.

2. The integrated circuit of claim 1, wherein the first conductive layer comprises titanium and phosphorous.

3. The integrated circuit of claim 1 or 2, wherein the source or drain region comprises silicon and phosphorous.

4. The integrated circuit of any one of claims 1 through 3, wherein the contact structure further comprises a third conductive layer on the second conductive layer, wherein the third conductive layer comprises molybdenum.

5. The integrated circuit of any one of claims 1 through 4, wherein the contact structure is a first contact structure and the integrated circuit further comprises a second contact structure on a top surface of the source or drain region.

6. The integrated circuit of claim 5, wherein the second contact structure comprises a conductive layer having titanium and phosphorous.

7. The integrated circuit of any one of claims 1 through 6, further comprising a backside conductive trace below the dielectric layer and a conductive contact extending between the backside conductive trace and the contact structure.

8. The integrated circuit of any one of claims 1 through 7, wherein the semiconductor device is a first semiconductor device and the contact structure is a first contact structure, the integrated circuit further comprising:
a second semiconductor device having a second semiconductor region extending in the first direction from a second source or drain region, and a second gate structure extending in the second direction over the second semiconductor region; and
a second contact structure on a bottom surface of the second source or drain region and adjacent to the dielectric layer, the second contact structure comprising a conductive layer having molybdenum.

9. The integrated circuit of claim 8, wherein the conductive layer is a third conductive layer, and the second contact structure further comprises a fourth conductive layer on the third conductive layer, the fourth conductive layer having titanium and boron.

10. The integrated circuit of claim 8 or 9, wherein the first source or drain region is an n-type region and the second source or drain region is a p-type region.

11. The integrated circuit of any one of claims 1 through 10, wherein the semiconductor region comprises a plurality of semiconductor nanoribbons.

12. The integrated circuit of claim 11, wherein the plurality of semiconductor nanoribbons comprise germanium, silicon, or a combination thereof.

13. A printed circuit board comprising the integrated circuit of any one of claims 1 through 12.

14. A method of forming an integrated circuit, the method comprising:
forming a fin comprising semiconductor material, the fin extending above a substrate;
forming a dielectric layer adjacent to a subfin of the fin;
forming sacrificial gates and spacer structures over the fin;
removing portions of the fin not covered by the sacrificial gates and spacer structures;
removing a portion of the subfin to form a subfin recess;
forming a sacrificial plug within the subfin recess;
forming a source or drain region at exposed ends of the semiconductor material above the sacrificial plug;
removing the substrate to expose a backside of the sacrificial plug;
removing the sacrificial plug from the backside;
forming a first conductive layer on a bottom surface of the source or drain region;
forming a second conductive layer on the first conductive layer, wherein the second conductive layer comprises scandium; and
forming a conductive contact beneath the second conductive layer.

15. The method of claim 14, wherein forming the first conductive layer comprises forming a layer comprising titanium and phosphorous, and forming the source or drain region comprises epitaxially growing silicon doped with phosphorous the method further comprising:
removing a remaining portion of the subfin from the backside; and forming a dielectric fill in place of the remaining portion of the subfin;
forming a conductive trace beneath the dielectric fill, such that the conductive contact is coupled to the conductive trace; and
replacing the sacrificial gate with a gate structure over the semiconductor material.
